# EUROPEAN PATENT APPLICATION

(11) **EP 4 644 791 A1**
(43) Date of publication of application: **05.11.2025**
(21) Application number: 24839859.6
(22) Date of filing: 11.04.2024
(51) Int. Cl.: F24F 1/22, H05K 5/06, F24F 1/56, F24F 1/46

(54) **OUTDOOR UNIT OF AIR CONDITIONER**

(30) Priority: 10.07.2023 KR 20230089450
(71) Applicant: Samsung Electronics Co., Ltd., Suwon-si, Gyeonggi-do 16677 (KR)
(72) Inventor: SUN, Woong, Suwon-si Gyeonggi-do 16677 (KR); KOH, Jeonguk, Suwon-si Gyeonggi-do 16677 (KR); PARK, Jaechan, Suwon-si Gyeonggi-do 16677 (KR); SHIN, Kwangnam, Suwon-si Gyeonggi-do 16677 (KR); YUK, Chungwan, Suwon-si Gyeonggi-do 16677 (KR); YUN, Seungjin, Suwon-si Gyeonggi-do 16677 (KR)
(74) Representative: Walaski, Jan Filip
(86) International application number: PCT/KR2024/004832
(87) International publication number: WO 2025/014040

(57) **Abstract**

An outdoor unit of an air conditioner is provided. The outdoor unit includes a case configured to accommodate a printed circuit board therein and including a case opening formed on one side of the case and a frame provided along an edge of the case opening, a case cover configured to cover at least a portion of the frame and the case opening and having a rear surface facing the inside of the case, and a gasket configured to seal a gap between the case cover and the frame. The frame includes a first surface disposed to face the rear surface of the case cover, and a second surface extending from the first surface toward the inside of the case. The gasket includes a first sealing portion configured to be in contact with the rear surface of the case cover and the first surface of the frame, and a second sealing portion configured to be in contact with the second surface of the frame.

## Description

### [Technical Field]

The disclosure relates to an outdoor unit of an air conditioner. More particularly, the disclosure relates to an outdoor unit of an air conditioner including a control box.

### [Background Art]

An air conditioner is an apparatus for regulating a temperature, humidity, airflow, distribution, and the like suitable for human activity using a refrigeration cycle. A compressor, a condenser, an evaporator, a blowing fan, and the like are included as main components constituting the refrigeration cycle.

Air conditioners may be classified into a separate air conditioner in which indoor and outdoor units are installed separately, and an integrated air conditioner in which indoor and outdoor units are installed together in one cabinet.

The outdoor unit of the separate air conditioner may include an outdoor heat exchanger for exchanging heat with outdoor air, a compressor for compressing a refrigerant, an expansion valve unit for depressurizing the refrigerant, and a blowing fan for generating an airflow. Also, the outdoor unit of the air conditioner may include a housing for accommodating the outdoor heat exchanger, the expansion valve unit, the compressor, and the blowing fan. A control box in which a printed circuit board assembly for controlling the air conditioner is accommodated may be disposed inside the housing.

The above information is presented as background information only to assist with an understanding of the disclosure. No determination has been made, and no assertion is made, as to whether any of the above might be applicable as prior art with regard to the disclosure.

### [Disclosure]

### [Technical Problem]

Aspects of the disclosure are to address at least the above-mentioned problems and/or disadvantages and to provide at least the advantages described below. Accordingly, an aspect of the disclosure is to provide an outdoor unit of an air conditioner having an improved structure to prevent foreign substances from being introduced into a control box.

Another aspect of the disclosure is to provide an outdoor unit of an air conditioner having an improved structure to prevent a refrigerant from being introduced into a control box.

Another aspect of the disclosure is to provide an outdoor unit of an air conditioner having an improved structure to prevent a fire from occurring due to a flammable substance coming into contact with electronic components or wires inside a control box.

Another aspect of the disclosure is to provide an outdoor unit of an air conditioner having an improved structure to prevent a fire from spreading due to a flammable substance inside the outdoor unit.

Additional aspects will be set forth in part in the description which follows and, in part, will be apparent from the description, or may by learned by practice of the presented embodiments.

### [Technical Solution]

In accordance with an aspect of the disclosure, an outdoor unit of an air conditioner is provided. The outdoor unit may include a case configured to accommodate a printed circuit board therein and including a case opening formed on one side of the case and a frame provided along an edge of the case opening, a case cover configured to cover at least a portion of the frame and the case opening and having a rear surface facing the inside of the case, and a gasket configured to seal a gap between the case cover and the frame. The frame may include a first surface disposed to face the rear surface of the case cover, and a second surface extending from the first surface toward the inside of the case. The gasket may include a first sealing portion configured to be in contact with the rear surface of the case cover and the first surface of the frame, and a second sealing portion configured to be in contact with the second surface of the frame.

In accordance with another aspect of the disclosure, an outdoor unit of an air conditioner is provided. The outdoor unit may include a case configured to accommodate a printed circuit board therein and including a case opening formed on one side of the case and a frame provided along an edge of the case opening, a case cover configured to be able to be coupled to the case to cover at least a portion of the frame and the case opening when coupled to the case, and a gasket configured on a rear surface of the case cover to seal a gap between the case cover and the frame when the case cover is coupled to the case. The gasket may include a first sealing portion configured to be in contact with a first surface of the frame facing the rear surface of the case cover when the case cover is coupled to the case, and a second sealing portion configured to be in contact with a second surface of the frame extending from the first surface toward the inside of the case when the case cover is coupled to the case.

In accordance with another aspect of the disclosure, an outdoor unit of an air conditioner is provided. The outdoor unit may include a printed circuit board, a case forming an accommodation space in which the printed circuit board is accommodated and including a case opening formed on one side of the accommodation space and a frame provided along a circumference of the case opening, a case cover covering at least a portion of the frame and the case opening, and a gasket disposed between the case cover and the frame. The case cover may include a rear surface facing the accommodation space and a cover rib protruding from the rear surface toward the accommodation space. The frame may include a first surface facing the rear surface of the case cover, and a second surface connected to the first surface and facing the cover rib. The gasket may include a first sealing portion configured to seal a gap between the first surface and the rear surface of the case cover, and a second sealing portion configured to seal a gap between the second surface and the cover rib.

Other aspects, advantages, and salient features of the disclosure will become apparent to those skilled in the art from the following detailed description, which, taken in conjunction with the annexed drawings, discloses various embodiments of the disclosure.

### [Description of Drawings]

The above and other aspects, features, and advantages of certain embodiments of the disclosure will be more apparent from the following description taken in conjunction with the accompanying drawings, in which:
FIG. 1 illustrates an air conditioner according to an embodiment of the disclosure;
FIG. 2 illustrates an outdoor unit of the air conditioner according to an embodiment of the disclosure;
FIG. 3 is an exploded view of the outdoor unit of the air conditioner according to an embodiment of the disclosure;
FIG. 4 is an enlarged view of a control box in the outdoor unit of the air conditioner according to an embodiment of the disclosure;
FIG. 5 is an exploded view of a first control box in the outdoor unit of the air conditioner according to an embodiment of the disclosure;
FIG. 6 is an exploded view of a second control box in the outdoor unit of the air conditioner according to an embodiment of the disclosure;
FIG. 7 is an enlarged view of a portion of the second control box in the outdoor unit of the air conditioner according to an embodiment of the disclosure;
FIG. 8 is an exploded view of a partial configuration of the second control box in the outdoor unit of the air conditioner according to an embodiment of the disclosure;
FIG. 9 is an enlarged view of a portion of a second cover included in the outdoor unit of the air conditioner according to an embodiment of the disclosure;
FIG. 10 is an enlarged view of a portion of a second gasket included in the outdoor unit of the air conditioner according to an embodiment of the disclosure;
FIG. 11 is an enlarged view of a portion of a second case included in the outdoor unit of the air conditioner according to an embodiment of the disclosure;
FIG. 12 is a cross-sectional view illustrating that the second cover is separated from the second case in the outdoor unit of the air conditioner according to an embodiment of the disclosure;
FIG. 13 is a cross-sectional view illustrating that the second cover is coupled to the second case in the outdoor unit of the air conditioner according to an embodiment of the disclosure;
FIG. 14 is an exploded view of the second cover included in the outdoor unit of the air conditioner according to an embodiment of the disclosure;
FIG. 15 is a cross-sectional perspective view of the second control box with a case cover removed in the outdoor unit of the air conditioner according to an embodiment of the disclosure;
FIG. 16 is an exploded view of the second case included in the outdoor unit of the air conditioner according to an embodiment of the disclosure;
FIG. 17 is a front view of a partial configuration of the second control box in the outdoor unit of the air conditioner according to an embodiment of the disclosure;
FIG. 18 illustrates a second outer case included in the outdoor unit of the air conditioner according to an embodiment of the disclosure;
FIG. 19 illustrates the inside of the second case included in the outdoor unit of the air conditioner according to an embodiment of the disclosure; and
FIG. 20 is a view illustrating that the outdoor unit of the air conditioner is cut away and viewed from the rear according to an embodiment of the disclosure.

Throughout the drawings, it should be noted that like reference numbers are used to depict the same or similar elements, features, and structures.

### [Mode for Invention]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

In connection with the description of the drawings, like reference numbers may be used for like or related elements.

In this document, each of phrases such as "A or B," "at least one of A and B," "at least one of A or B," "A, B or C," "at least one of A, B and C," and "at least one of A, B, or C" may include any one of the items listed together in the corresponding one of the phrases, or all possible combinations thereof.

The term "and/or" includes any combination of a plurality of related components or any one of a plurality of related components.

Terms such as "first," "second," "primary," and "secondary" may simply be used to distinguish a given component from other corresponding components, and do not limit the corresponding components in any other respect (e.g., importance or order).

When any (e.g., first) component is referred to as being "coupled" or "connected" to another (e.g., second) component with or without the terms "functionally" or "communicatively", this means that the any component may be connected to the other component directly (e.g., by wire), wirelessly, or through a third component.

The terms "comprises" and "has" are intended to indicate that there are features, numbers, steps, operations, components, parts, or combinations thereof described in this document, and do not exclude the presence or addition of one or more other features, numbers, steps, operations, components, parts, or combinations thereof.

When any component is referred to as being "connected", "coupled", "supported" or "in contact" with another component, this includes a case in which the components are indirectly connected, coupled, supported, or in contact with each other through a third component as well as directly connected, coupled, supported, or in contact with each other.

When any component is referred to as being located "on" or "over" another component, this includes not only a case in which any component is in contact with another component but also a case in which another component is present between the two components.

Air conditioners according to various embodiments, which are apparatuses that perform functions such as air purification, ventilation, humidity control, cooling, or heating in an air conditioning space (hereinafter referred to as "indoor space"), refer to apparatuses equipped with at least one of these functions.

According to one embodiment, an air conditioner may include a heat pump device to perform a cooling function or a heating function. The heat pump device may include a refrigeration cycle in which a refrigerant circulates through a compressor, a first heat exchanger, an expansion device, and a second heat exchanger. All components of the heat pump device may be built into a single housing forming an exterior of the air conditioner, and such an air conditioner corresponds to a window-type air conditioner or a mobile air conditioner. On the other hand, some components of the heat pump device may be divided and built into a plurality of housings forming a single air conditioner, and such an air conditioner corresponds to a wall-mounted air conditioner, a stand-type air conditioner, and a system air conditioner.

The air conditioner including the plurality of housings may include at least one outdoor unit installed outdoors and at least one indoor unit installed indoors. As an example, the air conditioner may be configured such that a single outdoor unit and a single indoor unit are connected through a refrigerant pipe. As an example, the air conditioner may be configured such that a single outdoor unit is connected to two or more indoor units through refrigerant pipes. As an example, the air conditioner may be configured such that two or more outdoor units and two or more indoor units are connected through a plurality of refrigerant pipes.

The outdoor unit may be electrically connected to the indoor unit. For example, information (or commands) for controlling the air conditioner may be input through an input interface provided on the outdoor or indoor unit, and the outdoor unit and indoor unit may be operated simultaneously or sequentially in response to user input.

The air conditioner may include an outdoor heat exchanger provided in the outdoor unit, an indoor heat exchanger provided in the indoor unit, and a refrigerant pipe connecting the outdoor heat exchanger and the indoor heat exchanger.

The outdoor heat exchanger may perform heat exchange between a refrigerant and outdoor air using a phase change (e.g., evaporation or condensation) of the refrigerant. For example, while the refrigerant is condensing in the outdoor heat exchanger, the refrigerant may emit heat to the outdoor air, and while the refrigerant flowing in the outdoor heat exchanger is evaporating, the refrigerant may absorb heat from the outdoor air.

The indoor unit is installed indoors. As an example, the indoor units may be classified into a ceiling-type indoor unit, a stand-type indoor unit, a wall-mounted indoor unit, etc., depending on an arrangement method. As an example, the ceiling-type indoor units may be classified into a four-way indoor unit, a one-way indoor unit, and a duct-type indoor unit depending on a method in which air is discharged.

Likewise, the indoor heat exchanger may perform heat exchange between the refrigerant and indoor air using the phase change (e.g., evaporation or condensation) of the refrigerant. For example, while the refrigerant is evaporating in an indoor unit, the refrigerant may absorb heat from the indoor air, and an indoor space may be cooled by blowing the indoor air cooled through the cooled indoor heat exchanger. Also, while the refrigerant is condensing in the indoor heat exchanger, the refrigerant may emit heat into the indoor air, and the indoor space may be heated by blowing the indoor air heated through the high-temperature indoor heat exchanger.

That is, the air conditioner performs a cooling or heating function through a phase change process of the refrigerant circulating along the outdoor heat exchanger and the indoor heat exchanger, and thus may include a compressor to compress the refrigerant in order to circulate the refrigerant. The compressor may intake refrigerant gas through an intake hole to compress the refrigerant gas. The compressor may discharge a high-temperature and high-pressure refrigerant gas through a discharge hole. The compressor may be disposed inside the outdoor unit.

The refrigerant may circulate sequentially along the compressor, outdoor heat exchanger, expansion device, and indoor heat exchanger through the refrigerant pipe, or sequentially along the compressor, indoor heat exchanger, expansion device, and outdoor heat exchanger through the refrigerant pipe.

As an example, in a case in which one outdoor unit and one indoor unit are directly connected through the refrigerant pipe, the air conditioner may be configured such that the refrigerant circulates between the one outdoor unit and the one indoor unit through the refrigerant pipe.

As an example, in a case in which one outdoor unit is connected to two or more indoor units through the refrigerant pipes, the air conditioner may be configured such that the refrigerants flow to a plurality of the indoor units through the refrigerant pipes branched from the outdoor unit. The refrigerants discharged from the plurality of indoor units may join and circulate to the outdoor unit. As an example, the plurality of indoor units may be connected directly to the one outdoor unit in parallel through the separate refrigerant pipes, respectively.

Each of the plurality of indoor units may be operated independently depending on an operation mode set by a user. That is, some of the plurality of indoor units may be operated in a cooling mode, while the others of the plurality of indoor units may be operated in a heating mode. At this time, the refrigerant may be selectively introduced into each of the indoor units in a high or low pressure state along a designated circulation route through a flow path switching valve, which will be described later, and then may be discharged from each of the indoor units and circulate to the outdoor unit.

As an example, in a case in which two or more outdoor units and two or more indoor units are connected through the plurality of refrigerant pipes, the air conditioner may be configured such that the refrigerants discharged from the plurality of outdoor units may join and flow through one of the refrigerant pipes, and then be separated again at a certain point and be introduced into the plurality of indoor units.

All of the plurality of outdoor units may be all driven or at least some of them may not be driven depending on an operating load according to an amount of operation of the plurality of indoor units. In this case, the air conditioner may be configured such that the refrigerant is introduced into and circulates along an outdoor unit that is selectively driven through the flow path switching valve. The air conditioner may include an expansion device in order to lower a pressure of the refrigerant to be introduced into a heat exchanger. As an example, the expansion device may be disposed inside an indoor unit or inside an outdoor unit, or may be disposed inside the both.

As an example, the expansion device may lower a temperature and pressure of the refrigerant using a throttling effect. The expansion device may include an orifice capable of reducing a cross-sectional area of a flow path. The temperature and pressure of the refrigerant passed through the orifice may be lowered.

As an example, the expansion device may be implemented as an electronic expansion valve capable of adjusting an opening ratio (ratio of a cross-sectional area of a flow path of a valve in a partially opened state to a cross-sectional area of the flow path of the valve in a fully opened state). Depending on the opening rate of the electronic expansion valve, an amount of refrigerant passing through the expansion device may be controlled.

The air conditioner may further include a flow path switching valve disposed on a refrigerant circulation flow path. The flow path switching valve may include, for example, a four-way valve. The flow path switching valve may determine a refrigerant circulation route depending on the operation mode of the indoor unit (for example, cooling operation or heating operation). The flow path switching valve may be connected to a discharge side of the compressor.

The air conditioner may include an accumulator. The accumulator may be connected to an intake side of the compressor. A low-temperature and low-pressure refrigerant evaporated in the indoor heat exchanger or the outdoor heat exchanger may be introduced into the accumulator.

When the refrigerant, which is a mixture of refrigerant liquid and refrigerant gas, is introduced therein, the accumulator may separate the refrigerant liquid from the refrigerant gas and supply the refrigerant gas from which the refrigerant liquid has been separated to the compressor.

An outdoor fan may be provided adjacent to the outdoor heat exchanger. The outdoor fan may blow outdoor air to the outdoor heat exchanger to promote heat exchange between the refrigerant and the outdoor air.

The outdoor unit of the air conditioner may include at least one sensor. As an example, the sensor of the outdoor unit may be provided as an environmental sensor. The outdoor unit sensor may be disposed at any location inside or outside the outdoor unit. As an example, the outdoor unit sensors may include a temperature sensor for detecting an air temperature around the outdoor unit, a humidity sensor for detecting an air humidity around the outdoor unit, a refrigerant temperature sensor for detecting a refrigerant temperature of the refrigerant pipe passing through the outdoor unit, or a refrigerant pressure sensor for detecting a refrigerant pressure of the refrigerant pipe passing through the outdoor unit.

The outdoor unit of the air conditioner may include an outdoor unit communication device. The outdoor unit communication device may be provided to receive a control signal from a controller of the indoor unit of the air conditioner, which will be described later. The outdoor unit may control an operation of the compressor, the outdoor heat exchanger, the expansion device, the flow path switching valve, the accumulator, or the outdoor fan based on a control signal received through the outdoor unit communication device. The outdoor unit may transmit a sensing value detected from the outdoor unit sensor to the controller of the indoor unit through the outdoor unit communication device.

The indoor unit of the air conditioner may include a housing, a blower for circulating air to the inside or outside of the housing, and an indoor heat exchanger for exchanging heat with air introduced into the housing.

The housing may include an intake hole. Indoor air may be introduced into the inside of the housing through the intake hole.

The indoor unit of the air conditioner may include a filter provided to filter out foreign substances in air to be introduced into the housing through the intake hole.

The housing may include a discharge hole. Air flowing inside the housing may be discharged to the outside of the housing through the discharge hole.

An airflow guide may be provided in the housing of the indoor unit to guide a direction of air to be discharged through the discharge hole. As an example, the airflow guide may include a blade located on the discharge hole. As an example, the airflow guide may include an auxiliary fan for regulating a discharge airflow. The airflow guide is not limited thereto and may be omitted.

An indoor heat exchanger and a blower disposed on a flow path connecting the intake hole and the discharge hole may be provided inside the housing of the indoor unit.

The blower may include an indoor fan and a fan motor. As an example, the indoor fan may include an axial fan, a diagonal flow fan, a crossflow fan, or a centrifugal fan.

The indoor heat exchanger may be disposed between the blower and the discharge hole, or between the intake hole and the blower. The indoor heat exchanger may absorb heat from air introduced through the intake hole or transfer heat to air introduced through the intake hole. The indoor heat exchanger may include a heat exchange pipe through which the refrigerant flows, and heat exchange fins in contact with the heat exchange pipe to increase a heat transfer area.

The indoor unit of the air conditioner may include a drain tray disposed below the indoor heat exchanger to collect condensate generated from the indoor heat exchanger. The condensate collected in the drain tray may be drained to the outside through a drain hose. The drain tray may be provided to support the indoor heat exchanger.

The indoor unit of the air conditioner may include an input interface. The input interface may include any type of user input means, including a button, switch, touch screen, and/or touch pad. The user may directly input setting data (for example, desired indoor temperature, settings of operation modes for cooling/heating/dehumidification/air purification, settings of discharge hole selection, and/or settings of wind volume) through the input interface.

The input interface may be connected to an external input device. For example, the input interface may be electrically connected to a wired remote controller. The wired remote controller may be installed at a specific location in the indoor space (e.g., a portion of a wall). The user may input setting data related to an operation of the air conditioner by manipulating the wired remote controller. An electrical signal corresponding to the setting data obtained through the wired remote controller may be transmitted to the input interface. Also, the input interface may include an infrared sensor. The user may remotely input the setting data related to the operations of the air conditioner using a wireless remote controller. The setting data input through the wireless remote controller may be transmitted to the input interface as an infrared signal.

Also, the input interface may include a microphone. A voice command of the user may be obtained through the microphone. The microphone may convert the voice command of the user into an electrical signal and transmit the converted electrical signal to the indoor unit controller. The indoor unit controller may control the components of the air conditioner in order to execute a function corresponding to the voice command of the user. The setting data (for example, desired indoor temperature, settings of the operation modes for cooling/heating/dehumidification/air purification, settings of discharge hole selection, and/or settings of wind volume) obtained through the input interface may be transmitted to the indoor unit controller, which will be described later. As an example, the setting data obtained through the input interface may be transmitted to the outside, that is, the outdoor unit or a server, through an indoor unit communication device, which will be described later.

The indoor unit of the air conditioner may include a power module. The power module may be connected to an external power source to supply power to components of the indoor unit.

The indoor unit of the air conditioner may include an indoor unit sensor. The indoor unit sensor may be an environmental sensor disposed in a space inside or outside the housing. As an example, the indoor unit sensor may include one or more temperature sensors and/or humidity sensors disposed in a predetermined space inside or outside the housing of the indoor unit. As an example, the indoor unit sensor may include a refrigerant temperature sensor for detecting a refrigerant temperature of the refrigerant pipe passing through the indoor unit. As an example, the indoor unit sensor may include each refrigerant temperature sensor for detecting an inlet, middle, and/or outlet temperature of the refrigerant pipe passing through the indoor heat exchanger.

As an example, each environmental information detected by the indoor unit sensor may be transmitted to the indoor unit controller, which will be described later, or may be transmitted to the outside through the indoor unit communication device, which will be described later.

The indoor unit of the air conditioner may include the indoor unit communication device. The indoor unit communication device may include at least one of a short-range communication module and a long-distance communication module. The indoor unit communication device may include at least one antenna for wireless communication with other devices. The outdoor unit may include the outdoor unit communication device. The outdoor unit communication device may also include at least one of a short-range wireless communication module and a long-distance communication module.

The short-range wireless communication module may include, but is not limited thereto, a Bluetooth communication module, a Bluetooth low energy (BLE) communication module, a near field communication module, a wireless local area network (WLAN) (Wi-Fi) communication module, a ZigBee communication module, an infrared data association (IrDA) communication module, a Wi-Fi direct (WFD) communication module, an ultra-wideband (UWB) communication module, an Ant+ communication module, microwave (U-wave) communication module, and the like.

The long-distance communication module may include a communication module performing various types of long-distance communication and may include a mobile communication device. The mobile communication device transmits and receives wireless signals to and from at least one of a base station, an external terminal, and a server on a mobile communication network.

The indoor unit communication device may communicate with external devices such as a server, a mobile device, and another home appliance through a nearby access point (AP). The access point (AP) may connect a local area network (LAN) to which the air conditioner or a user device is connected to a wide area network (WAN) to which the server is connected. The air conditioner or the user device may be connected to the server via the wide area network (WAN). The indoor unit of the air conditioner may include the indoor unit controller to control the components of the indoor unit, including the blower. The outdoor unit of the air conditioner may include the outdoor unit controller to control components in the outdoor unit, including the compressor. The indoor unit controller may communicate with the outdoor unit controller through the indoor unit communication device and the outdoor unit communication device. The outdoor unit communication device may transmit a control signal generated by the outdoor unit controller to the indoor unit communication device, or may transmit a control signal transmitted from the indoor unit communication device to the outdoor unit controller. That is, the outdoor unit and the indoor unit may perform two-way communication. The outdoor and indoor units may transmit and receive various signals generated while the air conditioner is operating.

The outdoor unit controller may be electrically connected to the components in the outdoor unit and control an operation of each of the components. For example, the outdoor unit controller may adjust a frequency of the compressor and control the flow path switching valve to change a circulation direction of the refrigerant. The outdoor unit controller may control a rotational speed of the outdoor fan. The outdoor unit controller may also generate a control signal to adjust an opening degree of the expansion valve. Under the control of the outdoor unit controller, the refrigerant may circulate along a refrigerant circulation circuit including the compressor, flow path switching valve, outdoor heat exchanger, expansion valve, and indoor heat exchanger.

Various temperature sensors included in the outdoor and indoor units may transmit electrical signals corresponding to the detected temperatures, respectively, to the outdoor unit controller and/or the indoor unit controller. For example, the humidity sensors included in the outdoor and indoor units may transmit electrical signals corresponding to the detected humidity, respectively, to the outdoor unit controller and/or the indoor unit controller.

The indoor unit controller may obtain user input from the user device, including the mobile device, through the indoor unit communication device, and may obtain user input directly through the input interface or through the remote controller. The indoor unit controller may control the components of the indoor unit, including the blower, in response to the received user input. The indoor unit controller may transmit information about the received user input to the outdoor unit controller of the outdoor unit.

The outdoor unit controller may control the components in the outdoor unit, including the compressor, based on the information about the user input received from the indoor unit. For example, when a control signal corresponding to user input for selecting an operation mode such as cooling operation, heating operation, blowing operation, defrosting operation, or dehumidification operation is received from the indoor unit, the outdoor unit controller may control the components in the outdoor unit so that the operation of the air conditioner corresponding to the selected operation mode is performed.

Each of the outdoor unit controller and the indoor unit controller may include a processor and memory. The indoor unit controller may include at least one first processor and at least one first memory, and the outdoor unit controller may include at least one second processor and at least one second memory.

The memory may remember/store a variety of information necessary for the operations of the air conditioner. The memory may store instructions, applications, data and/or programs necessary for the operations of the air conditioner. For example, the memory may store various programs for a cooling operation, heating operation, dehumidification operation, and/or defrosting operation of the air conditioner. The memory may include a volatile memory such as a static random access memory (S-RAM) and a dynamic random access memory (D-RAM) for temporarily remembering data. Also, the memory may include a non-volatile memory such as a read only memory (ROM), an erasable programmable read only memory (EPROM), and an electrically erasable programmable read only memory (EEPROM) for long-term storage of data.

The processor may generate control signals for controlling the operations of the air conditioner based on instructions, applications, data, and/or programs stored in memory. The processor, which is hardware, may include logic circuits and arithmetic circuits. The processor may process data according to programs and/or instructions provided from the memory and generate control signals depending on the processed results. The memory and processor may be implemented as one control circuit or as a plurality of circuits.

The indoor unit of the air conditioner may include an output interface. The output interface may be electrically connected to the indoor unit controller and may output information related to the operations of the air conditioner under the control of the indoor unit controller. For example, information such as an operation mode, wind direction, wind volume, and temperature selected by user input may be output. The output interface may also output sensing information and warning/error messages obtained from the indoor unit sensor or the outdoor unit sensor.

The output interface may include a display and a speaker. The speaker is an audio device that may output various sounds. The display may display information input by the user or information provided to the user as various graphic elements. For example, operation information of the air conditioner may be displayed as at least one of an image and text. The display may also include an indicator providing specific information. The display may include a liquid crystal display panel (LCD panel), a light emitting diode panel (LED panel), an organic light emitting diode panel (OLED panel), a micro LED panel, and/or a plurality of LEDs.

Hereinafter, embodiments according to the disclosure will be described with reference to the attached drawings.

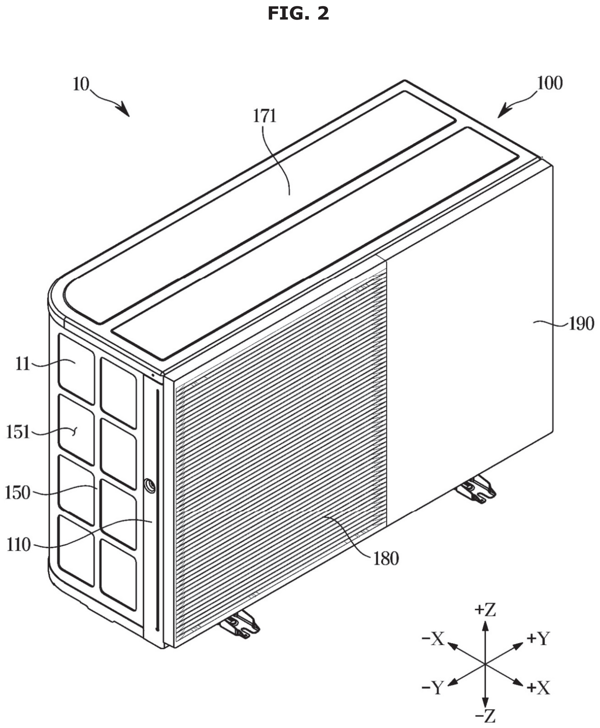

The terms "upward," "downward," "front," "rear," etc. used in the following description are defined based on the drawings, and the shape and location of each component are not limited by these terms. For example, referring to FIG. 2, a direction to which an outlet grill 180 and a front cover 190 each direct in an outdoor unit 10 of an air conditioner 1 according to an embodiment of the disclosure may be defined as a forward direction (+X direction), and a direction opposite thereto may be defined as a rearward direction (-X direction). Also, a vertical direction to which a top cover 171 directs in the outdoor unit 10 of the air conditioner 1 may be defined as an upward direction (+Z direction), and a direction opposite thereto may be defined as a downward direction (-Z direction). Also, a direction in which a first side frame 150 is located in the outdoor unit 10 of the air conditioner 1 may be defined as a left direction (-Y direction), and a direction opposite thereto may be defined as a right direction (+Y direction).

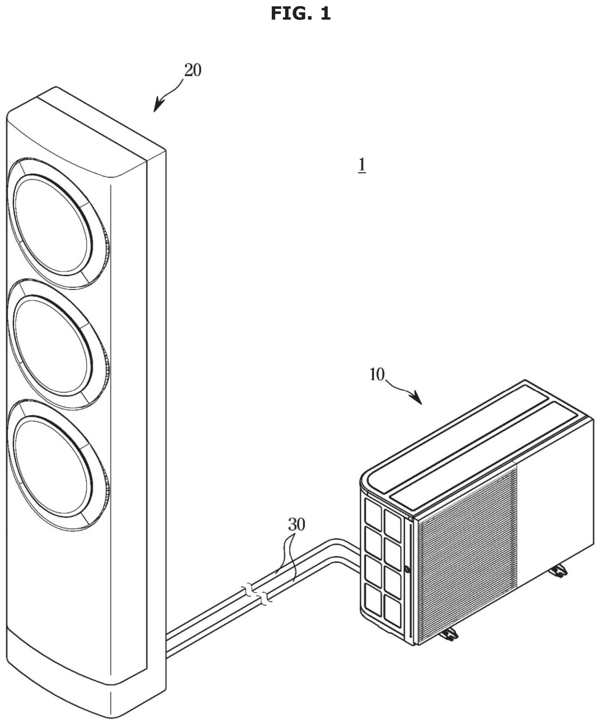

FIG. 1 illustrates an air conditioner according to an embodiment of the disclosure.

Referring to FIG. 1, the air conditioner 1 according to an embodiment of the disclosure may include an indoor unit 20 disposed in an indoor space and the outdoor unit 10 disposed in an outdoor space.

The air conditioner 1 may absorb heat inside an air conditioning space and emit heat outside the air conditioning space in order to cool the air conditioning space that is a subject to air conditioning. Also, the air conditioner 1 may absorb heat outside the air conditioning space and emit heat inside the air conditioning space in order to heat the air conditioning space.

The outdoor unit 10 may exchange heat with outdoor air outside the air conditioning space. The outdoor unit 10 may perform heat exchange between a refrigerant and outdoor air using a phase change of the refrigerant (e.g., evaporation or condensation). For example, the outdoor unit 10 may emit heat from the refrigerant to the outdoor air using condensation of the refrigerant. Also, the outdoor unit 10 may absorb heat from the outdoor air into the refrigerant using evaporation of the refrigerant.

FIG. 1 illustrates the one outdoor unit 10, but the number of the outdoor units 10 is not limited to that illustrated in FIG. 1. For example, the air conditioner 1 may include a plurality of the outdoor units 10.

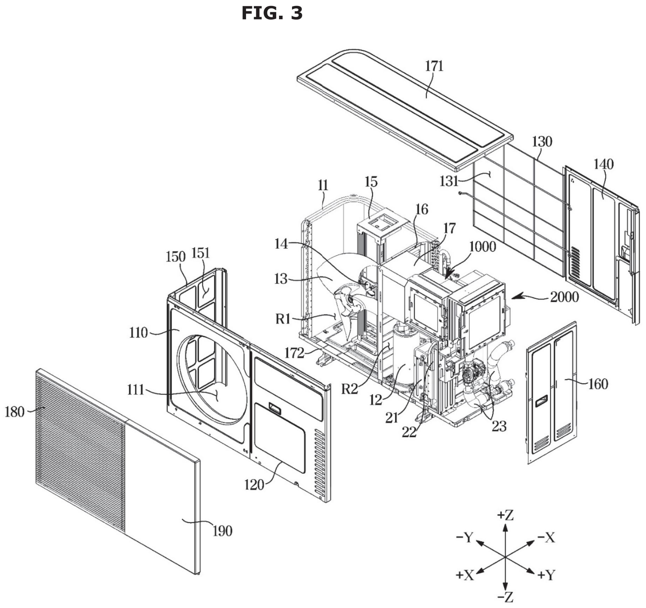

The outdoor unit 10 may include an outdoor heat exchanger 11 (see FIG. 3) provided to exchange heat with outdoor air and a compressor 12 (see FIG. 3) provided to compress refrigerant gas.

A detailed explanation of the components in the outdoor unit 10 will be described later.

The indoor unit 20 may exchange heat with indoor air within the air conditioning space. The indoor unit 20 may perform heat exchange between the refrigerant and indoor air using the phase change of the refrigerant (e.g., evaporation or condensation). For example, the indoor unit 20 may cool the air conditioning space by absorbing heat from the indoor air into the refrigerant using evaporation of the refrigerant. Also, the indoor unit 20 may heat the air conditioning space by emitting heat from the refrigerant to the indoor air using the condensation of the refrigerant.

The indoor unit 20 may include an indoor heat exchanger provided to exchange heat with indoor air, an indoor blowing fan provided to intake and blow the indoor air so that the indoor air passes through the indoor heat exchanger, and an expansion valve unit provided to depressurize and expand the refrigerant.

FIG. 1 illustrates the one indoor unit 20, but the number of the indoor units 20 is not limited to that illustrated in FIG. 1. For example, the air conditioner may include a plurality of the indoor units 20. The plurality of different indoor units 20 may be installed in a plurality of the different air conditioning spaces.

As such, the air conditioner 1 may perform heat exchange between the refrigerant outside the air conditioning space and outdoor air and heat exchange between the refrigerant and indoor air within the air conditioning space.

In this case, the air conditioner 1 may include a refrigerant pipe 30 provided to transfer the refrigerant between the indoor unit 20 and the outdoor unit 10 in order to transfer heat between the outside of the air conditioning space and the inside of the air conditioning space. The refrigerant pipe 30 may allow the refrigerant to flow between the outside of the air conditioning space and the inside of the air conditioning space. The outdoor unit 10 may be connected to the indoor unit 20 to each other through the refrigerant pipe 30 delivering the refrigerant.

The air conditioner 1 described above is only an example of an air conditioner to which the outdoor unit of the air conditioner according to the disclosure may be applied, and the disclosure is not limited thereto. Configurations such as an air conditioner to which the outdoor unit of the air conditioner according to the disclosure may be applied, and components included therein such as the indoor unit and the refrigerant pipe may be provided in various ways.

Hereinafter, the outdoor unit 10 of the air conditioner 1 according to an embodiment of the disclosure will be described in detail with reference to FIGS. 2 to 20.

FIG. 2 illustrates an outdoor unit of the air conditioner according to an embodiment of the disclosure. FIG. 3 is an exploded view of the outdoor unit of the air conditioner according to an embodiment of the disclosure.

Referring to FIGS. 2 and 3, the outdoor unit 10 of the air conditioner 1 according to an embodiment of the disclosure may include an outdoor heat exchanger 11 provided to exchange heat with outdoor air, a compressor 12 provided to compress the refrigerant, an outdoor fan 13 provided to intake and blow the outdoor air so that the outdoor air passes through the outdoor heat exchanger 11, and a housing 100 forming an exterior of the outdoor unit 10.

The housing 100 may form the exterior of the outdoor unit 10. Various components in the outdoor unit 10, such as the outdoor heat exchanger 11, the compressor 12, the outdoor fan 13, and control boxes 1000 and 2000, which will be described later, may be accommodated inside the housing 100.

The housing 100 may include inlet holes 131 and 151 formed to allow air to be introduced, and a discharge hole 111 formed to allow air to be discharged. As the outdoor fan 13 rotates, air outside the housing 100 may be introduced through the inlet holes 131 and 151 and may exchange heat with the outdoor heat exchanger 11 and then be discharged to the outside of the housing 100 through the discharge hole 111.

The outdoor unit 10 may include a heat exchange room R1 formed inside the housing 100. Outdoor air may be introduced into the heat exchange room R1, and the introduced air may be discharged back to the outside. In the heat exchange room R1, heat exchange may be performed between the outdoor heat exchanger 11 and air introduced from the outside. In the heat exchange room R1, components such as the outdoor heat exchanger 11 and the outdoor fan 13 may be disposed.

The outdoor unit 10 may include a machine room R2 formed inside the housing 100. In the machine room R2, components such as the compressor 12 and the control boxes 1000 and 2000, which will be described later, may be disposed.

Inside the housing 100, the heat exchange room R1 and the machine room R2 may be partitioned from each other. The outdoor unit 10 may include a partition 16 partitioning the heat exchange room R1 and the machine room R2. The partition 16 may be disposed between the heat exchange room R1 and the machine room R2. As an example, the heat exchange room R1 and the machine room R2 may be arranged in left and right directions (Y directions) in the drawings, and the partition 16 may be disposed to extend in upward and downward directions (Z directions) in the drawings to partition the heat exchange room R1 and the machine room R2.

As an example, the housing 100 may be formed to have a substantially box shape.

An example of a structure of the housing 100 will be described below.

The housing 100 may include a first front frame 110. The first front frame 110 may cover the front (+X direction) of the heat exchange chamber R1. The discharge hole 111 may be formed on the first front frame 110.

The housing 100 may include a second front frame 120. The second front frame 120 may cover the front (+X direction) of the heat exchange chamber R1. As an example, the second front frame 120 may be formed in a substantially flat plate shape.

As an example, the first front frame 110 and the second front frame 120 may be arranged side by side in the left and right directions (Y directions). The first front frame 110 and the second front frame 120 may be coupled to each other.

As an example, a plurality of heat dissipation holes may be formed on the second front frame 120 so that the machine room R2 may communicate with the outside of the outdoor unit 10 to dissipate heat within the machine room R2.

The housing 100 may include a first rear frame 130. The first rear frame 130 may form one part of a rear exterior of the outdoor unit 10. The first rear frame 130 may be disposed at the rear (-X direction) of the heat exchange room R1. The inlet hole 131 may be formed on the first rear frame 130.

The first front frame 110 and the first rear frame 130 may be arranged to face each other.

The housing 100 may include a second rear frame 140. The second rear frame 140 may form another part of the rear exterior of the outdoor unit 10. The second rear frame 140 may cover the rear (-X direction) of the machine room R2.

As an example, a plurality of heat dissipation holes may be formed on the second rear frame 140 so that the machine room R2 may communicate with the outside of the outdoor unit 10 to dissipate heat within the machine room R2.

The second front frame 120 and the second rear frame 140 may be arranged to face each other.

The housing 100 may include a first side frame 150. The first side frame 150 may form one surface of the outdoor unit 10 in the left direction (-Y direction).

The first side frame 150 may cover the heat exchange room R1. The first side frame 150 may cover the heat exchange room R1 from the left direction (-Y direction). The inlet hole 151 may be formed on the first side frame 150.

The first side frame 150 may be coupled to the first front frame 110. The first side frame 150 may be connected to the first rear frame 130.

As an example, the first side frame 150 may be disposed to extend in the forward and rearward directions (X directions).

The housing 100 may include a second side frame 160. The second side frame 160 may form one surface of the outdoor unit 10 in the right direction (+Y direction).

The second side frame 160 may cover the machine room R2. The second side frame 160 may cover the machine room R2 from the right direction (+Y direction).

As an example, a plurality of heat dissipation holes may be formed on the second side frame 160 so that the machine room R2 may communicate with the outside of the outdoor unit 10 to dissipate heat within the machine room R2.

The second side frame 160 may be coupled to the second front frame 120. The second side frame 160 may be coupled to the second rear frame 140.

As an example, the second side frame 160 may be disposed to extend in the forward and rearward directions (X directions).

The first side frame 150 and the second side frame 160 may be arranged to face each other.

The housing 100 may include a base 172. The base 172 may form a bottom surface of the outdoor unit 10. The base 172 may be disposed on one side of the heat exchange room R1 and the machine room R2 in the downward direction (-Z direction). The base 172 may support the various components in the outdoor unit 10 accommodated inside the housing 100 from a lower side thereof.

The base 172 may be coupled to a lower portion of each of the first front frame 110, the second front frame 120, the second rear frame 140, the first side frame 150, and the second side frame 160.

The base 172 may be formed to have a substantially flat plate shape.

The housing 100 may include a top cover 171. The top cover 171 may form an upper surface of the outdoor unit 10.

The top cover 171 may cover upper sides (+Z direction) of the heat exchange room R1 and the machine room R2. The top cover 171 may cover the various components in the outdoor unit 10 accommodated inside the housing 100 from an upper side thereof.

The top cover 171 may be coupled to an upper portion of each of the first front frame 110, the second front frame 120, the second rear frame 140, the first side frame 150, and the second side frame 160.

The top cover 171 may be formed to have a substantially flat plate shape.

The top cover 171 and the base 172 may be arranged to face each other.

The housing 100 may include a discharge hole grill 180. The discharge hole grill 180 may cover the front (+X direction) of the first front frame 110. The discharge hole grill 180 may cover the front (+X direction) of the discharge hole 111. The discharge hole grill 180 may be coupled to the first front frame 110. The discharge hole grill 180 may form one part of a front exterior of the outdoor unit 10.

The discharge hole grill 180 covers the discharge hole 111, and may be formed to have a substantially grill shape so that air may be discharged from the discharge hole 111.

The housing 100 may include the front cover 190. The front cover 190 may cover the front (+X direction) of the second front frame 120. The front cover 190 may be coupled to the second front frame 120. The front cover 190 may form another part of the front exterior of the outdoor unit 10.

As an example, the discharge hole grill 180 and the front cover 190 may be arranged side by side in the left and right directions (Y directions). The discharge hole grill 180 and the front cover 190 may be coupled to each other.

Each component included in the housing 100 may be provided to be separable from each other. As an example, the second front frame 120 may be provided to be separable from the first front frame 110, the second side frame 160, the top cover 171, and the base 172. As an example, the second side frame 160 may be provided to be separable from the second front frame 120, the second rear frame 140, the top cover 171, and the base 172. As an example, the top cover 171 may be provided to be separable from the first front frame 110, the second front frame 120, the second rear frame 140, the first side frame 150, and the second side frame 160.

Accordingly, when it is necessary to perform work such as inspecting, replacing, or repairing components within the outdoor unit 10, a worker may perform the work by separating at least one component of the housing 100.

The configuration of the housing that may be included in the air conditioner according to the disclosure is not limited to what has been described above.

The outdoor heat exchanger 11 may be provided to exchange heat with outdoor air. The outdoor heat exchanger 11 may be provided such that the refrigerant flows therein. In the outdoor heat exchanger 11, heat exchange between the refrigerant and the outdoor air may be performed.

For example, during the cooling operation of the air conditioner 1, high-pressure and high-temperature refrigerant gas may be condensed in the outdoor heat exchanger 11, and the refrigerant may dissipate heat to the outdoor air while the refrigerant is condensing. During the cooling operation of the air conditioner 1, the outdoor heat exchanger 11 may discharge refrigerant liquid.

Also, during the heating operation of the air conditioner 1, low-temperature and low-pressure refrigerant liquid is evaporated in the outdoor heat exchanger 11, and the refrigerant may absorb heat from the outdoor air while the refrigerant is evaporating. During the heating operation of the air conditioner 1, the outdoor heat exchanger 11 may discharge refrigerant gas.

The outdoor heat exchanger 11 may be disposed to face the inlet holes 131 and 151 in the heat exchange room R1.

The compressor 12 may compress refrigerant gas and discharge high-temperature and high-pressure refrigerant gas. For example, the compressor 12 may include a motor and a compression mechanism, and the compression mechanism may compress refrigerant gas by a torque of the motor.

The outdoor unit 10 may include the outdoor fan 13 provided to flow air, and a fan motor 14 provided to generate a rotational force for rotating the outdoor fan 13.

As an example, the outdoor unit 10 may include a motor bracket 15 provided to support the outdoor fan 13 and the fan motor 14. The motor bracket 15 may be disposed in the heat exchange room R1.

As an example, the outdoor unit 10 may include a plate heat exchanger 21. The plate heat exchanger 21 may be provided to exchange heat between the refrigerant and water. The plate heat exchanger 21 may be disposed inside the housing 100. As an example, the plate heat exchanger 21 may be disposed in the machine room R1.

As an example, the outdoor unit 10 may include a water pipe 23 provided to allow water to be introduced from or discharged to the outside. The water pipe 23 may be connected to the plate heat exchanger 21. At least a portion of the water pipe 23 may be disposed inside the housing 100. As an example, at least a portion of the water pipe 23 may be disposed in the machine room R1.

Water introduced into the outdoor unit 10 from the outside through the water pipe 23 may exchange heat with a high-temperature refrigerant within the plate heat exchanger 21. The water in the plate heat exchanger 21 may absorb heat from the high-temperature refrigerant and be discharged back to the outside of the outdoor unit 10 through the water pipe 23.

As an example, the outdoor unit 10 may include an expansion tank 22. When a water temperature rises by the plate heat exchanger 21, a volume in the water pipe 23 may increase, and thus the expansion tank 22 may be provided to prevent a water pressure from suddenly rising. The expansion tank 22 may be disposed inside the outdoor unit housing 100. As an example, the expansion tank 22 may be disposed in the machine room R2.

As such, the outdoor unit 10 according to one embodiment may constitute one part of a heating system supplying hot water, including the plate heat exchanger 21, the water pipe 23, and the expansion tank 22.

However, the disclosure is not limited thereto, and in the air conditioner according to one embodiment, the plate heat exchanger, the water pipe, and the expansion tank may be provided outside the outdoor unit. Or, the air conditioner according to one embodiment may not be equipped with the heating system.

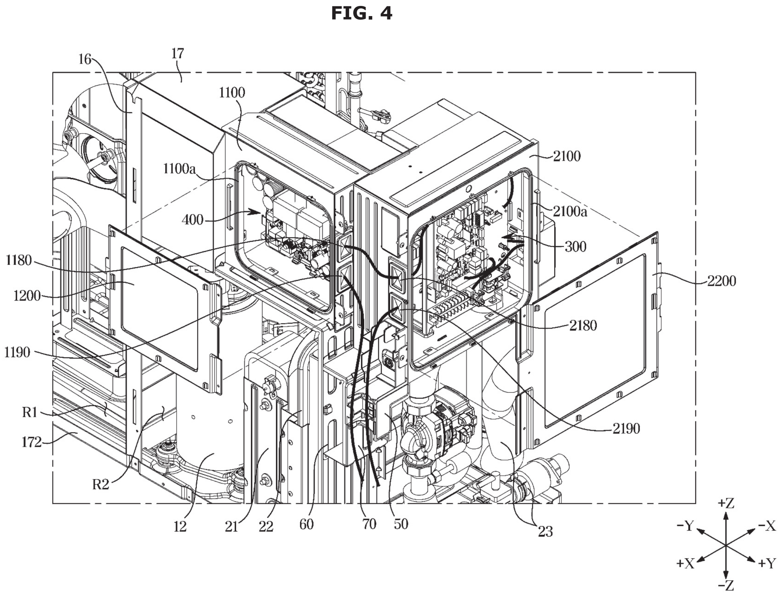

The outdoor unit 10 may include a plurality of printed circuit boards 200, 300 and 400 (see FIGS. 4, 5, 6, etc.) to control operations of the various components in the outdoor unit 10. Various electronic components may be mounted on the plurality of printed circuit boards 200, 300 and 400. The outdoor unit 10 may include the control boxes 1000 and 2000 to accommodate the plurality of printed circuit boards 200, 300 and 400.

For example, the outdoor unit 10 may include the first control box 1000. The first control box 1000 may be accommodated inside the housing 100. The first control box 1000 may be disposed in the machine room R2.

As illustrated in FIG. 3, as an example, the first control box 1000 may be located at a front part of the machine room R2 and may be covered by the second front frame 120.

For example, the outdoor unit 10 may include the second control box 2000. The second control box 2000 may be accommodated inside the housing 100. The second control box 2000 may be disposed in the machine room R2.

As illustrated in FIG. 3, as an example, the second control box 2000 may be located at a right side of the machine room R2 and may be covered by the second side frame 160.

As an example, the outdoor unit 10 may include a duct 17. The duct 17 may be provided such that the inside of the first control box 1000 communicates with the heat exchange room R1. Alternatively, the duct 17 may be provided such that the inside of the second control box 2000 communicates with the heat exchange room R1.

When the outdoor fan 13 is driven, by a suction force of the outdoor fan 13, air may flow from each of the first control box 1000 and the second control box 2000 to the heat exchange room R1 through the duct 17. Accordingly, heat generated inside the first control box 1000 and the second control box 2000 may be dissipated to the outside.

The configuration of the outdoor unit 10 described above is only an example of an outdoor unit of the air conditioner according to the disclosure, and the disclosure is not limited thereto. The outdoor unit of the air conditioner according to the disclosure may be configured in various ways to allow outdoor air to be introduced through the inlet holes and to allow the introduced air to be discharged to the outside after heat exchange.

FIG. 4 is an enlarged view of a control box in the outdoor unit of the air conditioner according to an embodiment of the disclosure.

Referring to FIG. 4, the outdoor unit 10 of the air conditioner 1 according to an embodiment of the disclosure may include the first control box 1000 and the second control box 2000.

The first control box 1000 and the second control box 2000 may be provided to accommodate some of the plurality of printed circuit boards provided in the outdoor unit 10, respectively.

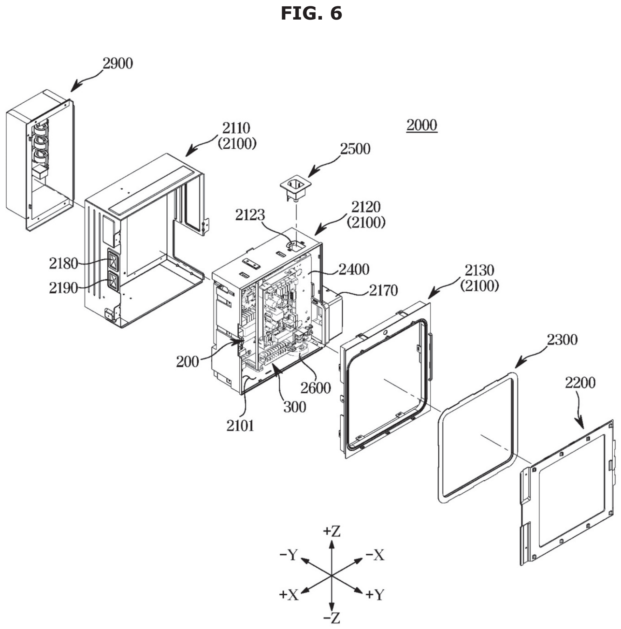

For example, the outdoor unit 10 may include the first printed circuit board 200 (see FIG. 6), the second printed circuit board 300, and the third printed circuit board 400. The first control box 1000 and the second control box 2000 may be provided to accommodate some of the first printed circuit board 200 (see FIG. 6), the second printed circuit board 300, and the third printed circuit board 400, respectively.

As an example, the first printed circuit board 200 (see FIG. 6) may be accommodated in the first control box 1000. As an example, the second printed circuit board 300 may be accommodated in the second control box 2000. As an example, the third printed circuit board 400 may be accommodated in the second control box 2000.

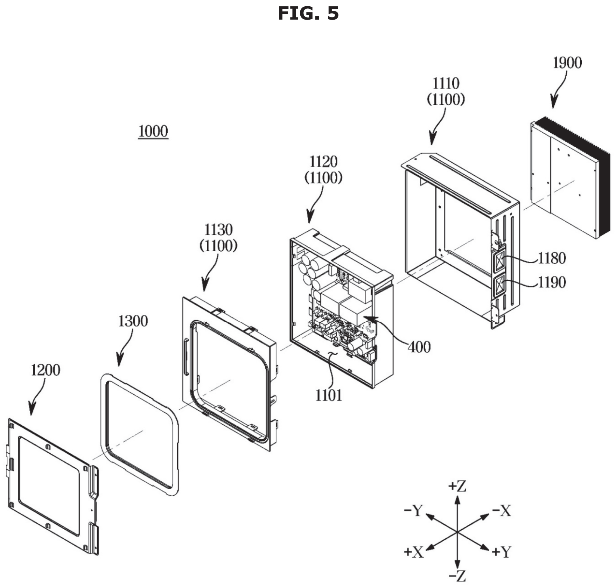

The first control box 1000 may include a first case 1100. As an example, the first case 1100 may be provided to accommodate the third printed circuit board 400. A first accommodation space 1101 (see FIG. 5) may be formed in the first case 1100 to accommodate the third printed circuit board 400.

The first case 1100 may be formed such that one side thereof is open. That is, the first case 1100 may include a first case opening 1100a formed on the one side. For example, the third printed circuit board 400 may be inserted into or withdrawn from the first case 1100 through the first case opening 1100a. The worker may perform work by accessing the third printed circuit board 400 accommodated inside the first case 1100 through the first case opening 1100a.

As an example, the first case opening 1100a may be formed on one side of the front (+X direction) of the first case 1100. That is, the first case 1100 may be formed such that the front (+X direction) of the first case 1100 is open. However, the disclosure is not limited thereto, and a direction in which the one side of the first case 1100 is open may be designed in various ways depending on factors such as a location of the first case 1100 within the housing 100.

As an example, the first case 1100 may be formed to have a substantially box shape.

The first control box 1000 may include a first case cover 1200 provided to be detachably coupled to the first case 1100. The first case cover 1200 may be coupled to the first case 1100 to close the first case opening 1100a. The first case cover 1200 may be separated from the first case 1100 to open the first case opening 1100a. For example, a manufacturer of the first control box 1000 may insert the third printed circuit board 400 into the first case 1100 and then couple the first case cover 1200 to the first case 1100, thereby covering an inner space of the first case 1100. The worker, who intends to inspect the third printed circuit board 400 inside the first control box 1000 or replace or repair a component, may access the third printed circuit board 400 by separating the first case cover 1200 from the first case 1100.

As an example, the first case cover 1200 may be coupled to the front (+X direction) of the first case 1100. That is, the first case cover 1200 may cover the third printed circuit board 400 from the front (+X direction).

As an example, the first case cover 1200 may be formed in a substantially flat plate shape.

As such, the third printed circuit board 400 inside the first case 1100 may be normally protected from an external impact, foreign substances introduced from the outside, leaked refrigerant gas, and the like by the first case cover 1200. In addition, as the first case cover 1200 may be removed when necessary, the worker may access the third printed circuit board 400.

The second control box 2000 may include a second case 2100. As an example, the second case 2100 may be provided to accommodate the first printed circuit board 200 (see FIG. 6). A second accommodation space 2101 may be formed in the second case 2100 to accommodate the first printed circuit board 200 (see FIG. 6) and the second printed circuit board 300.

The second case 2100 may be formed such that one side thereof is open. That is, the second case 2100 may include a second case opening 2100a formed on the one side. For example, the first printed circuit board 200 (see FIG. 6) and the second printed circuit board 300 may be inserted into or withdrawn from the second case 2100 through the second case opening 2100a. The worker may perform work by accessing the first printed circuit board 200 (see FIG. 6) or the second printed circuit board 300 accommodated inside the second case 2100 through the second case opening 2100a.

As an example, the second case opening 2100a may be formed on one side of the second case 2100 in the right direction (+Y direction). That is, the second case 2100 may be formed to be open in the right direction (+Y direction). However, the disclosure is not limited thereto, and a direction in which the one side of the second case 2100 is open may be designed in various ways depending on factors such as a location of the second case 2100 within the housing 100.

As an example, the second case 2100 may be formed to have a substantially box shape.

The second control box 2000 may include a second case cover 2200 provided to be detachably coupled to the second case 2100. The second case cover 2200 may be coupled to the second case 2100 to close the second case opening 2100a. The second case cover 2200 may be separated from the second case 2100 to open the second case opening 2100a. For example, a manufacturer of the second control box 2000 may insert the first printed circuit board 200 (see FIG. 6) and the second printed circuit board 300 into the second case 2100 and then couple the second case cover 2200 to the second case 2100, thereby covering an inner space of the second case 2100. The worker, who intends to inspect the first printed circuit board 200 (see FIG. 6) or the second printed circuit board 300 inside the second control box 2000 or replace or repair a component, may access the first printed circuit board 200 (see FIG. 6) and the second printed circuit board 300 by separating the second case cover 2200 from the second case 2100.

As an example, the second case cover 2200 may be coupled to the second case 2100 from the right direction (+Y direction). That is, the second case cover 2200 may cover the first printed circuit board 200 (see FIG. 6) and the second printed circuit board 300 from the right direction (+Y direction).

As an example, the second case cover 2200 may be formed in a substantially flat plate shape.

As such, the first printed circuit board 200 (see FIG. 6) and the second printed circuit board 300 inside the second case 2100 may be normally protected from an external impact, foreign substances introduced from the outside, leaked refrigerant gas, and the like by the second case cover 2200. In addition, as the second case cover 2200 may be removed when necessary, the worker may access the first printed circuit board 200 (see FIG. 6) or the second printed circuit board 300.

A detailed explanation of a structure of the second control box 2000 will be described later.

The plurality of printed circuit boards may be provided in the outdoor unit 10 to control the operations of the various components in the outdoor unit 10, such as the compressor 12, the fan motor 14, the plate heat exchanger 21, and the expansion tank 22. Alternatively, the plurality of printed circuit boards 200, 300, and 400 may be provided to receive detection signals from various sensors (not shown) provided in the compressor 12, the outdoor heat exchanger 11, and the like. The plurality of printed circuit boards may be electrically connected to the various components in the outdoor unit 10 through electric wires.

For example, the first printed circuit board 200 (see FIG. 6), the second printed circuit board 300, and the third printed circuit board 400 may be electrically connected to the various components in the outdoor unit 10 by electric wires. Or, the first printed circuit board 200, the second printed circuit board 300, and the third printed circuit board 400 may be electrically connected to each other through electric wires. Or, the first printed circuit board 200, the second printed circuit board 300, and the third printed circuit board 400 may be connected to devices (not shown) located outside the outdoor unit 10 by electric wires.

For example, the first printed circuit board 200 (see FIG. 6) may be connected to the third printed circuit board 400 by an electric wire penetrating the first case 1100 and the second case 2100. For example, the first printed circuit board 200 may be connected to the various components in the outdoor unit 10 by an electric wire penetrating the second case 2100. For example, the first printed circuit board 200 may be connected to the second printed circuit board 300 by an electric wire disposed inside the second case 2100.

For example, the second printed circuit board 300 may be connected to the third printed circuit board 400 by the electric wire penetrating the first case 1100 and the second case 2100. For example, the second printed circuit board 300 may be connected to the various components in the outdoor unit 10 by the electric wire penetrating the second case 2100. For example, the second printed circuit board 300 may be connected to the first printed circuit board 200 (see FIG. 6) by the electric wire disposed inside the second case 2100.

For example, the third printed circuit board 400 may be connected to the first printed circuit board 200 (see FIG. 6) or the second printed circuit board 300 by the electric wire penetrating the first case 1100 and the second case 2100. For example, the third printed circuit board 400 may be connected to the various components in the outdoor unit 10 by the electric wire penetrating the second case 2100.

The first case 1100 may include wire penetration parts 1180 and 1190 provided to allow wires to penetrate through. For example, the first case 1100 may include the first wire penetration part 1180 provided to allow an electric wire connecting the third printed circuit board 400 with the first printed circuit board 200 (see FIG. 6) or the second printed circuit board 300 to penetrate through. For example, the first case 1100 may include the second wire penetration part 1190 provided to allow electric wires connecting the third printed circuit board 400 with the various components in the outdoor unit 10 to penetrate through.

As an example, the first wire penetration part 1180 may be disposed above the second wire penetration part 1190, but is not limited thereto.

As an example, the wire penetration parts 1180 and 1190 of the first case 1100 may be provided on one side of the first case 1100 adjacent to the second case 2100. As an example, the wire penetration parts 1180 and 1190 of the first case 1100 may be provided on one surface of a right side of the first case 1100 (+Y direction side).

The second case 2100 may include wire penetration parts 2180 and 2190 provided to allow electric wires to penetrate through. For example, the second case 2100 may include the third wire penetration part 2180 provided to allow an electric wire connecting the first printed circuit board 200 (see FIG. 6) or the second printed circuit board 300 with the third printed circuit board 400 to penetrate through. For example, the second case 2100 may include the fourth wire penetration part 2190 provided to allow electric wires connecting the third printed circuit board 400 with the various components in the outdoor unit 10 to penetrate through.

As an example, the third wire penetration part 2180 may be disposed above the fourth wire penetration part 2190, but is not limited thereto.

As an example, the wire penetration parts 2180 and 2190 of the second case 2100 may be provided on one side of the second case 2100 adjacent to the first case 1100. As an example, the wire penetration parts 2180 and 2190 of the second case 2100 may be provided on one surface of the front of the second case 2100 (+X direction side).

As an example, the first printed circuit board 200 or the second printed circuit board 300 disposed inside the second control box 2000 may be connected to an external power source to receive power from the external power source, or may be connected to electric wires provided to transmit and receive communication signals with an external device. The second case 2100 may include an external wire penetration part 2170 (see FIG. 6) provided to allow electric wires to penetrate through. As an example, the external wire penetration part 2170 may be formed on one side of the rear (-X direction) of the second case 2100.

The outdoor unit 10 may include a wire guide 50. The wire guide 50 may be provided to fix/support some of the electric wires connected to the first printed circuit board 200 (see FIG. 6), the second printed circuit board 300, and the third printed circuit board 400. As an example, the wire guide 50 may be provided to fix/support an electric wire penetrating the second wire penetration part 1190 and the fourth wire penetration part 2290.

The first control box 1000 and the second control box 2000 may be supported within the housing 100.

For example, the outdoor unit 10 may include a first support frame 60 provided inside the housing 100. As an example, the first support frame 60 may support lower portions of the first control box 1000 and the second control box 2000. As an example, the first support frame 60 may be supported by the base 172.

For example, the outdoor unit 10 may include a second support frame 70 provided inside the housing 100. For example, the second support frame 70 may support the lower portion of the second control box 2000. As an example, the second support frame 70 may be supported by the first support frame 60.

The configurations of the first control box 1000 and the second control box 2000 described above are only examples of control boxes included in the outdoor unit of the air conditioner according to the disclosure to accommodate the printed circuit boards, and the disclosure is not limited thereto.

FIG. 5 is an exploded view of a first control box in the outdoor unit of the air conditioner according to an embodiment of the disclosure.

Referring to FIG. 5, the first case 1100 included in the first control box 1000 of the outdoor unit 10 of the air conditioner 1 according to an embodiment of the disclosure may be provided to accommodate the third printed circuit board 400. The first case 1100 may form the first accommodation space 1101 in which the third printed circuit board 400 is accommodated.

As described above, the first case 1100 may include the first case opening 1100a. The first case opening 1100a may be formed on one side of the first case 1100. The first case opening 1100a may be formed on one side of the first accommodation space 1101. In other words, the first case 1100 may be formed such that one side thereof is open. As an example, the first case 1100 may be formed such that the front (+X direction) thereof is open, and the first case opening 1100a may be formed on a front side (+X direction) of the first accommodation space 1101.

In detail, the first case 1100 of the first control box 1000 may include a first outer case 1110 and a first inner case 1120.

The first outer case 1110 may form an exterior of the first control box 1000. The first outer case 1110 may be disposed in the machine room R2. An outer surface of the first outer case 1110 may be disposed to be exposed to the machine room R2.

The first outer case 1110 may be supported by the housing 100 or components inside the housing 100. As an example, the first outer case 1110 may be supported by the first support frame 60.

As an example, the first outer case 1110 may be provided with the first wire penetration part 1180 and the second wire penetration part 1190 described above.

The first inner case 1120 may be provided inside the first outer case 1110. In detail, the first inner case 1120 may be coupled to the inside of the first outer case 1110.

The first inner case 1120 may be provided to accommodate the third printed circuit board 400. The first inner case 1120 may form the first accommodation space 1101 in which the third printed circuit board 400 is accommodated. The third printed circuit board 400 may be mounted on the first inner case 1120.

The first outer case 1110 and the first inner case 1120 of the first case 1100 may each be open at the first case opening 1100a side. The first case opening 1100a of the first case 1100 may be regarded as the first case opening 1100a of the first outer case 1110, and may be regarded as the first case opening 1100a of the first inner case 1120.

The first case 1100 may include a first frame 1130. The first frame 1130 may be provided along an edge of the first case opening 1100a. In detail, the first frame 1130 may have a shape of extending from the edge of the first case opening 1100a toward the outside of the edge.

As an example, the first frame 1130 may be coupled to one side of the first inner case 1120 in the direction of the first case opening 1100a.

A detailed explanation of the first case 1100 of the first control box 1000 will be described later.

The first case cover 1200 of the first control box 1000 may be provided to be able to be coupled to the first case 1100. The first case cover 1200 may be provided to cover the first case opening 1100a. The first case cover 1200 may be provided to cover at least a portion of the first frame 1130.

In detail, the first case cover 1200 may be provided to cover the first case opening 1100a by being coupled to the first case 1100. Also, the first case cover 1200 may be provided to cover at least a portion of the first frame 1130 by being coupled to the first case 1100.

In other words, the first case cover 1200 may be formed to have a size large enough to cover the first case opening 1100a and further cover at least a portion of the first frame 1130. That is, when the first case cover 1200 is coupled to the first case 1100, an edge of the first case cover 1200 may be positioned outside the edge of the first case opening 1100a.

A detailed explanation of the first case cover 1200 of the first control box 1000 will be described later.

The first control box 1000 may include a first gasket 1300 provided to seal a gap between the first case 1100 and the first case cover 1200. In detail, the first gasket 1300 may be provided to seal a gap between the first case cover 1200 and the first frame 1130 when the first case cover 1200 is coupled to the first case 1100.

The first gasket 1300 may be provided to prevent foreign substances outside the first case 1100, and the refrigerant leaked from components disposed in the machine room R2 or the like from being introduced into the first case 1100.

A detailed explanation of the first gasket 1300 of the first control box 1000 will be described later.

As an example, the first control box 1000 may include a heat sink 1900. The heat sink 1900 may be provided to dissipate heat generated inside the first control box 1000 to the outside of the first control box 1000. In detail, the heat sink 1900 may be provided to dissipate heat generated by the third printed circuit board 400 to the outside of the first case 1100.

As an example, the heat sink 1900 may be connected to the third printed circuit board 400. The heat generated from the third printed circuit board 400 may be conducted to the heat sink 1900. The heat sink 1900 is provided with a plurality of heat dissipation fins, so heat dissipation efficiency may be improved.

As an example, the heat sink 1900 may be coupled to the rear (-X direction) of the first case 1100. In this case, the heat sink 1900 may be provided to dissipate heat toward the rear (-X direction) of the first case 1100.

However, the disclosure is not limited thereto, and the heat sink 1900 as illustrated in FIG. 5 may not be provided in the first control box 1000.

FIG. 6 is an exploded view of a second control box in the outdoor unit of the air conditioner according to an embodiment of the disclosure.

Referring to FIG. 6, the second case 2100 included in the second control box 2000 of the outdoor unit 10 of the air conditioner 1 according to an embodiment of the disclosure may be provided to accommodate the first printed circuit board 200 and the second printed circuit board 300. The second case 2100 may form the second accommodation space 2101 in which the first printed circuit board 200 and the second printed circuit board 300 are accommodated.

As described above, the second case 2100 may include the second case opening 2100a. The second case opening 2100a may be formed on one side of the second case 2100. The second case opening 2100a may be formed on one side of the second accommodation space 2101. In other words, the second case 2100 may be formed such that one side thereof is open. As an example, the second case 2100 may be formed to be open in the right direction (+Y direction), and the second case opening 2100a may be formed on a right side (+Y direction) of the second accommodation space 2101.

In detail, the second case 2100 of the second control box 2000 may include a second outer case 2110 and a second inner case 2120.

The second outer case 2110 may form an exterior of the second control box 2000. The second outer case 2110 may be disposed in the machine room R2. An outer surface of the second outer case 2110 may be disposed to be exposed to the machine room R2.

The second outer case 2110 may be supported by the housing 100 or the components inside the housing 100. As an example, the second outer case 2110 may be supported by the first support frame 60 and the second support frame 70.

As an example, the second outer case 2110 may be provided with the third wire penetration part 2180 and the fourth wire penetration part 2190 described above.

The second inner case 2120 may be provided inside the second outer case 2110. In detail, the second inner case 2120 may be coupled to the inside of the second outer case 2110.

The second inner case 2120 may be provided to accommodate the first printed circuit board 200 and the second printed circuit board 300. The second inner case 2120 may form the second accommodation space 2101 in which the first printed circuit board 200 and the second printed circuit board 300 are accommodated. The first printed circuit board 200 and the second printed circuit board 300 may be mounted on the second inner case 2120.

The second outer case 2110 and the second inner case 2120 of the second case 2100 may each be open at the second case opening 2100a side. The second case opening 2100a of the second case 2100 may be regarded as the second case opening 2100a of the second outer case 2110, and may be regarded as the second case opening 2100a of the second inner case 2120.

As an example, as illustrated in FIG. 6, the first printed circuit board 200 may be disposed further inside the second case 2100 than the second printed circuit board 300. That is, the first printed circuit board 200 may be disposed to be located further inward than the second printed circuit board 300 from the second case opening 2100a of the second case 2100.

As an example, the first printed circuit board 200 may be mounted on an inner surface of the second case 2100 opposite the second case opening 2100a.

As an example, the second control box 2000 may include a board frame 2400. The board frame 2400 may be provided to support the second printed circuit board 300. The second printed circuit board 300 may be mounted on the board frame 2400.

As such, as the first printed circuit board 200 and the second printed circuit board 300 are accommodated together inside the second case 2100 in a multi-layer structure arranged in the Y directions, space utilization within the second control box 2000 may be improved.

As an example, the board frame 2400 may be provided to be movable with respect to the second case 2100. As an example, the second control box 2000 may include a first frame guide 2500 and a second frame guide 2600 provided to guide a movement of the board frame 2400. The first frame guide 2500 and the second frame guide 2600 may movably support the board frame 2400.

As an example, the second inner case 2120 may include a guide mounting portion 2123 provided such that the first frame guide 2500, which will be described later, is mounted thereon. The first frame guide 2500 may be detachably mounted by the guide mounting portion 2123. The guide mounting portion 2123 may be formed to penetrate one surface of the inner case 2120. One portion of the first frame guide 2500 may pass through the guide mounting portion 2123 to be disposed inside the inner case 2120, and the other portion may be supported by an outer surface of the inner case 2120. As an example, as illustrated in FIG. 6, the guide mounting portion 2123 may be formed on an upper surface of the inner case 2120.

With this configuration, the worker may efficiently access the first printed circuit board 200 by moving the board frame 2400 as needed.

The second case 2100 may include a second frame 2130. The second frame 2130 may be provided along an edge of the second case opening 2100a. In detail, the second frame 2130 may have a shape of extending from the edge of the second case opening 2100a toward the outside of the edge.

As an example, the second frame 2130 may be coupled to one side of the second inner case 2120 in the direction of the second case opening 2100a.

The second case cover 2200 of the second control box 2000 may be provided to be able to be coupled to the second case 2100. The second case cover 2200 may be provided to cover the second case opening 2100a. The second case cover 2200 may be provided to cover at least a portion of the second frame 2130.

In detail, the second case cover 2200 may be provided to cover the second case opening 2100a by being coupled to the second case 2100. Also, the second case cover 2200 may be provided to cover at least a portion of the second frame 2130 by being coupled to the second case 2100.

In other words, the second case cover 2200 may be formed to have a size large enough to cover the second case opening 2100a and further cover at least a portion of the second frame 2130. That is, when the second case cover 2200 is coupled to the second case 2100, an edge of the second case cover 2200 may be positioned outside the edge of the second case opening 2100a.

The second control box 2000 may include a second gasket 2300 provided to seal a gap between the second case 2100 and the second case cover 2200. In detail, the second gasket 2300 may be provided to seal a gap between the second case cover 2200 and the second frame 2130 when the second case cover 2200 is coupled to the second case 2100.

The second gasket 2300 may be provided to prevent foreign substances outside the second case 2100, and the refrigerant leaked from components disposed in the machine room R2 or the like from being introduced into the second case 2100.

As an example, the second control box 2000 may include a noise filter unit 2900 provided to reduce current noise. As an example, the noise filter unit 2900 may be coupled to a left side (-Y direction) of the second case 2100.

The configurations of the first control box 1000 and the second control box 2000 described above with reference to FIGS. 5 and 6 are merely examples of configurations that control boxes provided in the outdoor unit of the air conditioner according to the disclosure may have, and the disclosure is not limited thereto.

For example, the outdoor unit of the air conditioner according to one embodiment may include a case in which the outer case, the inner case, and the frame are formed integrally rather than separately. Or, the frame may be formed integrally with a component of the case, such as the inner case.

The air conditioner 1 according to an embodiment of the disclosure may operate using heat exchange occurring in a process of evaporating/condensing the refrigerant, as described above. As such, there are many different types of refrigerants that may be used for the operation of the air conditioner 1.

However, some types of refrigerants that may be used in air conditioner 1 may include highly flammable substances. For example, R290 refrigerant, a type of refrigerant that may be used in refrigerant cycles of various types of air conditioners, including the air conditioner 1 according to one embodiment, is a natural hydrocarbon refrigerant containing propane and is an eco-friendly refrigerant with very low ozone depletion potential (ODP) and global warming potential (GWP), but has relatively high flammability compared to other types of refrigerants.

Therefore, when a highly flammable type of refrigerant such as the R290 refrigerant is used in the air conditioner 1 according to an embodiment, in a case in which the refrigerant leaks from the various components in the outdoor unit 10, such as the compressor 12, the outdoor heat exchanger 11, and the refrigerant pipes connecting them, there is a risk of fire. In particular, in a case in which the leaked refrigerant is introduced into the control boxes 1000 and 2000, when the refrigerant is exposed to various electronic components or electric wires within the control boxes 1000 and 2000, the possibility of a fire occurring may increase.

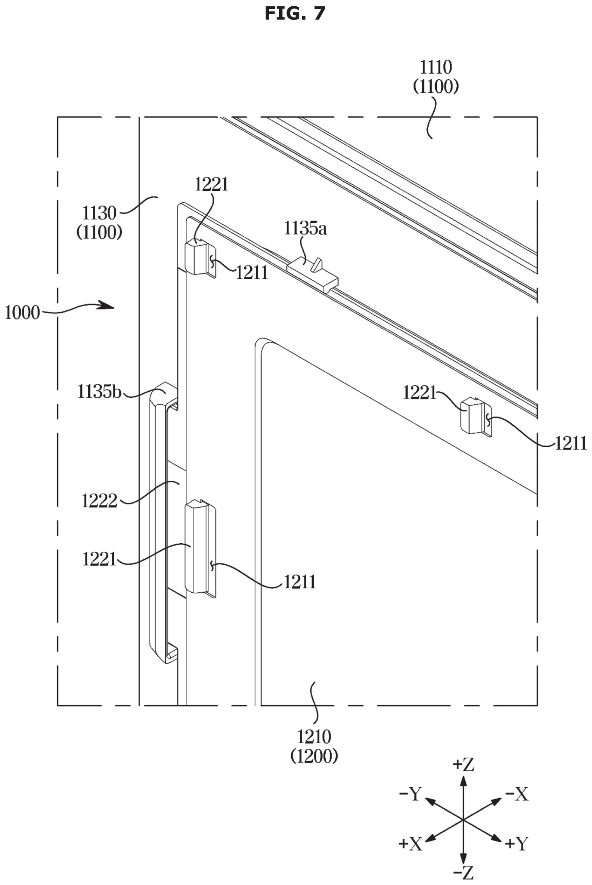

As will be described below with reference to FIGS. 7 to 20, the outdoor unit 10 of the air conditioner 1 according to an embodiment of the disclosure may include various components provided to prevent the refrigerant from being introduced into the control boxes 1000 and 2000 when a highly flammable refrigerant leaks from the various components in the outdoor unit 10 and to prevent the spread of a fire even when a fire occurs due to the refrigerant.

Hereinafter, components in the first control box 1000 of the outdoor unit 10 of the air conditioner 1 according to an embodiment of the disclosure will be described in detail with reference to FIGS. 7 to 20. However, some components of the first control box 1000 (e.g., the case 1100, case cover 1200, gasket 1300, etc.) may also be applied to the corresponding components in the second control box 2000, and thus a detailed description of the second control box 2000 will be omitted for convenience.

Hereinafter, for convenience of explanation, the first control box 1000 may be referred to as the 'control box 1000.' Also, the first case 1100 may be referred to as the 'case 1100.' Also, the first case opening 1100a may be referred to as the 'case opening 1100a.' Also, the first accommodation space 1101 may be referred to as the 'accommodation space 1101.' Also, the first outer case 1110 may be referred to as the 'outer case 1110.' Also, the first inner case 1120 may be referred to as the 'inner case 1120.' Also, the first frame 1130 may be referred to as the 'frame 1130.' Also, the first case cover 1200 may be referred to as the 'case cover 1200.' Also, the first gasket 1300 may be referred to as the 'gasket 1300.' Also, the third printed circuit board 400 may be referred to as the 'printed circuit board 400.'

FIG. 7 is an enlarged view of a portion of the second control box in the outdoor unit of the air conditioner according to an embodiment of the disclosure.

Referring to FIG. 7, in the outdoor unit 10 of the air conditioner 1 according to an embodiment of the disclosure, the case cover 1200 may be detachably coupled to the case 1100. As described above, the case cover 1200 may cover at least a portion of the frame 1130 and the case opening 1100a when coupled to the case 1100.

In detail, the case cover 1200 may be coupled to the frame 1130. The case cover 1200 may be coupled to the case 1100 by being coupled to the frame 1130. The case cover 1200 may be separated from the case 1100 by being separated from the frame 1130.

For example, the frame 1130 may include a first cover coupling part 1135a provided to fix the case cover 1200. The first cover coupling part 1135a may be provided to be coupled to an edge of the case cover 1200. In detail, the first cover coupling part 1135a may be formed to have a hook structure so as to be hook-coupled to the edge of the case cover 1200.

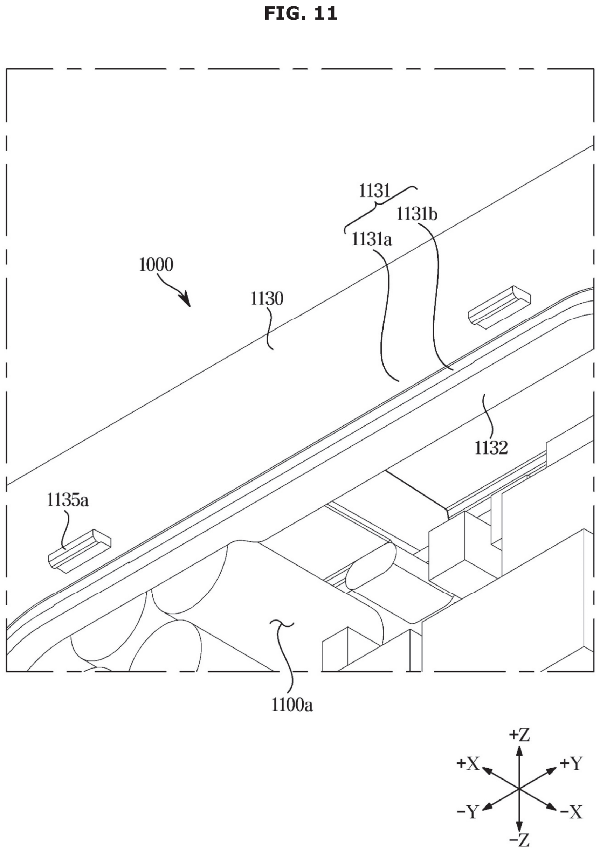

As an example, as illustrated in FIG. 7, the first cover coupling part 1135a may be formed to protrude from one surface of the frame 1130 (corresponding to a first surface 1131 of the frame 1130, which will be described later; see FIG. 11).

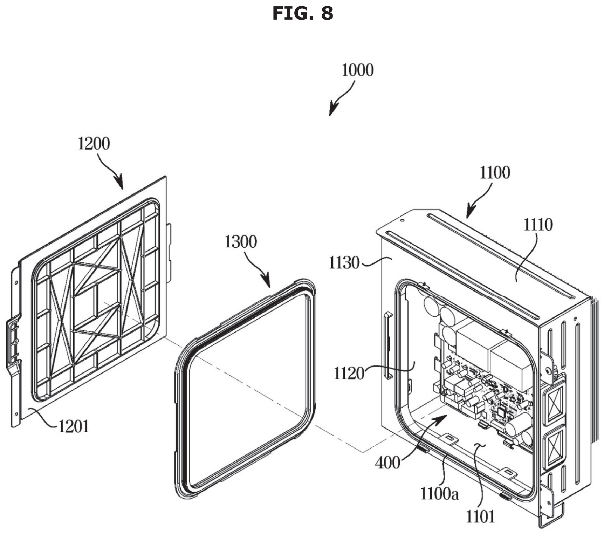

As an example, a plurality of the first cover coupling parts 1135a may be provided. As an example, the first cover coupling parts 1135a may be provided to be coupled to upper and lower edges of the case cover 1200, respectively (see FIG. 8).

With this configuration, the case cover 1200 may be firmly coupled to the frame 1130.

For example, the frame 1130 may include a second cover coupling part 1135b provided to fix the case cover 1200. The second cover coupling part 1135b may be disposed adjacent to one side of the edge of the case cover 1200. The second cover coupling part 1135b may be provided to be hook-coupled to one side of the edge of the case cover 1200.

Correspondingly, the case cover 1200 may include a frame locked part 1222 provided to be coupled to the second cover coupling part 1135b. The frame locked part 1222 may be formed on one side of the edge of the case cover 1200. The frame locked part 1222 may be provided to be hook-coupled to the second cover coupling part 1135b.

As an example, as illustrated in FIG. 7, the second cover coupling part 1135b may be formed to protrude from one surface of the frame 1130 (corresponding to the first surface 1131 of the frame 1130, which will be described later; see FIG. 11). The second cover coupling part 1135b may form an insertion space. An insertion space may be formed between the second cover coupling part 1135b and the one surface of the frame 1130 to allow the frame locked part 1222 to be inserted therein. When the frame locked part 1222 is inserted into the insertion space formed by the second cover coupling part 1135b, the frame locked part 1222 may be hook-coupled to the second cover coupling part 1135b.

With this configuration, the case cover 1200 may be firmly coupled to the frame 1130.

As an example, the outer case 1110 described above may include a metal material. In detail, as an example, the outer case 1110 may be manufactured through a process of pressing a metal plate material such as a steel plate.

As an example, the frame 1130 may include a resin material. In detail, as an example, the frame 1130 may be manufactured through a resin injection molding process. In a case in which the frame 1130 is manufactured through the resin injection molding process, for the efficiency of the manufacturing process, it may be appropriate for a structure of being relatively complex to be processed, such as a structure for firmly coupling the case cover 1200 and the frame 1130, to be provided on the frame 1130 rather than the outer case 1110.

In addition, because a structure of being formed by a resin injection may have a certain elasticity, the ease of assembly between the case cover 1200 and the frame 1130 may be improved, and it may also be easier for case cover 1200 to separate from frame 1130.

As such, it may be appropriate to form the first cover coupling part 1135a, the second cover coupling part 1135b, and the like for hook-coupling the case cover 1200 to the frame 1130 to the frame 1130.

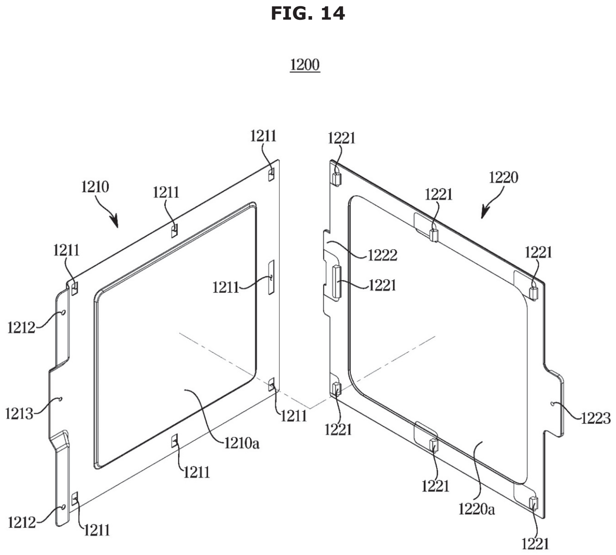

As will be described later, as an example, the case cover 1200 may include the outer cover 1210 and the inner cover 1220 (see FIG. 14). The outer cover 1210 and the inner cover 1220 may be coupled to each other. The outer cover 1210 and the inner cover 1220 may be coupled to each other to form the one case cover 1200.

In this case, as an example, the outer cover 1210 may include a metal material. In detail, as an example, the outer cover 1210 may be manufactured through the process of pressing a metal plate material such as a steel plate.

Also, as an example, the inner cover 1220 may include a resin material. In detail, as an example, the inner cover 1220 may be manufactured through the resin injection molding process. In a case in which the inner cover 1220 is manufactured through the resin injection molding process, for the efficiency of the manufacturing process, it may be appropriate for the structure of being relatively complex to be processed, such as the structure for firmly coupling the case cover 1200 and the frame 1130, to be provided on the inner cover 1220.

In addition, because the structure of being formed by the resin injection may have the certain elasticity, the ease of assembly between the case cover 1200 and the frame 1130 may be improved, and it may also be easier for case cover 1200 to separate from frame 1130.

Therefore, as in the case described above, it may be appropriate to form the frame locked part 1222 for hook-coupling the case cover 1200 to the frame 1130 to the inner cover 1220.

However, unlike the case described above, the frame 1130 may not include a resin material. Even in this case, a structure for coupling the case cover 1200 to the case 1100, such as the first cover coupling part 1135a and the second cover coupling part 1135b, may be provided on the frame 1130. Or, the case cover 1200 may be provided to be coupled to the case 1100 through a coupling structure provided on another component of the case 1100 other than the frame 1130.

For example, the case cover 1200 may include a case fastening part 1212 (see FIG. 14). In detail, the case fastening part 1212 may be provided on the outer cover 1210 (see FIG. 14), which will be described later. A screw hole through which a screw may penetrate may be formed on the case fastening part 1212.

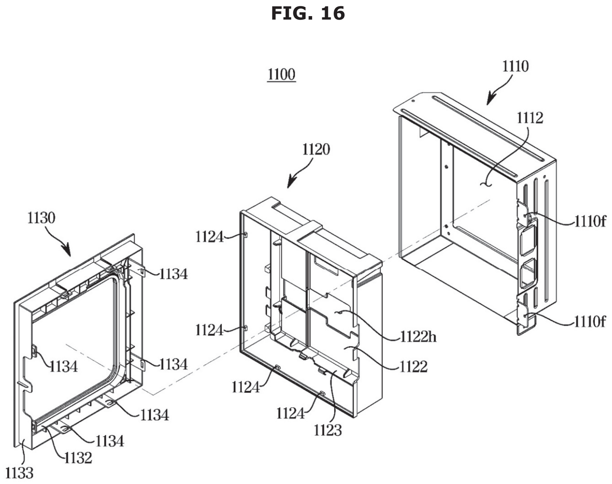

The case 1100 may include a cover fastening part 1110f (see FIG. 16). In detail, the cover fastening part 1110f may be provided on the outer case 1110. A screw hole through which a screw may penetrate may be formed on the cover fastening part 1110f.

The case cover 1200 and the case 1100 may be fastened by a screw penetrating the case fastening part 1212 and the outer case 1110.

As described above, the outer case 1110 may include a metal material. Therefore, in a case in which the cover fastening part 1110f is provided on the outer case 1110, the case cover 1200 may be firmly fastened to the case 1100 due to a high rigidity of the outer case 1110.

Likewise, as described above, the outer cover 1210 may include a metal material. Therefore, in a case in which the case fastening part 1212 is provided on the outer cover 1210, the case cover 1200 may be firmly fastened to the case 1100 due to a high rigidity of the outer cover 1210.

However, unlike the case described above, the outer case 1110 or the outer cover 1210 may not include a metal material. Even in this case, structures for screwing the case cover 1200 to the case 1100, such as the cover fastening part 1110f and the case fastening part 1212, are provided on the outer case 1110 and the outer cover 1210, respectively. In addition, the case cover 1200 may be provided to be screwed to the case 1100 through screw fastening structures provided to various configurations of the case 1100.

With this configuration, the case cover 1200 may be more firmly fixed to the case 1100, and the inside of the case 1100 may be more efficiently sealed by the case cover 1200. Accordingly, foreign substances or leaked refrigerant from the outside of the case 1100 may be prevented from being introduced into the inside of the case 1100, and in particular, a fire due to the leaked refrigerant may be effectively prevented.

The configurations for detachably coupling the case cover 1200 to the case 1100 described above with reference to FIG. 7 are only examples of coupling structures capable of being applied to the control box included in the outdoor unit of the air conditioner according to the disclosure, and the disclosure is not limited thereto.

FIG. 8 is an exploded view of a partial configuration of the second control box in the outdoor unit of the air conditioner according to an embodiment of the disclosure.

Referring to FIG. 8, the outdoor unit 10 of the air conditioner 1 according to an embodiment of the disclosure may include the gasket 1300.

Even when the case cover 1200 is firmly coupled to the case 1100 as described above, the gap may be formed between the case cover 1200 and the frame 1130 covered by the case cover 1200. In particular, in a case in which the case cover 1200 is provided to be detachable from the case 1100, due to design for convenience of assembly/separation, there is a possibility that a larger gap is formed between the case cover 1200 and the frame 1130. Therefore, when the refrigerant is introduced into the gap formed between the case cover 1200 and the frame 1130, the refrigerant may sequentially pass through the gap and the case opening 1100a and be introduced into the inside of the case 1100.

In order to solve this case, the gasket 1300 may be provided to seal the gap between the case cover 1200 and the frame 1130 when the case cover 1200 is coupled to the case 1100. The gasket 1300 may be disposed between the case cover 1200 and the frame 1130 when the case cover 1200 is coupled to the case 1100. The gasket 1300 may be provided to be in contact with the case cover 1200 and the frame 1130, respectively, when the case cover 1200 is coupled to the case 1100.

The gasket 1300 may include an elastically deformable material. As an example, the gasket 1300 may include various elastic materials such as rubber.

As such, as the gasket 1300 is provided to be elastically deformable, when the case cover 1200 is coupled to the case 1100, the gasket 1300 may be compressed between the case cover 1200 and the frame 1130. Therefore, not only may the case cover 1200 be easily coupled to the case 1100 without significant resistance, but also, after the case cover 1200 is coupled to the case 1100, the gap between the case cover 1200 and the frame 1130 may be efficiently sealed.

As an example, the gasket 1300 may be provided along an edge of the case opening 1100a. The gasket 1300 may be formed to have a shape substantially corresponding to the case opening 1100a. However, even when the shapes of the gasket 1300 and the case opening 1100a substantially correspond to each other, a size of the gasket 1300 may be provided to be larger than a size of the edge of the case opening 1100a.

As an example, the gasket 1300 may be provided on the case cover 1200. In detail, the gasket 1300 may be provided on a rear surface 1201 of the case cover 1200. Herein, the rear surface 1201 of the case cover 1200 refers to one surface of the case cover 1200 facing the inside of the case 1100 (in other words, a direction of facing the accommodation space 1101) when the case cover 1200 is coupled to the case 1100, and refers to a surface covering the case opening 1100a and at least a portion of one surface of the frame 1130 (corresponding to the first surface 1131 of the frame 1130, which will be described later). As an example, when the case cover 1200 is coupled to the case 1100, the rear surface 1201 of the case cover 1200 may face the rear (-X direction), and may cover the case opening 1100a and at least a portion of the first surface 1131, which is a front surface of the case 1100 facing the front (+X direction).

As an example, the gasket 1300 may be provided along a circumferential direction of the case cover 1200. In detail, the gasket 1300 may be provided along the circumferential direction of the case cover 1200 at a position adjacent to the edge of the case cover 1200.

As an example, the gasket 1300 may be coupled to the case cover 1200. In detail, the gasket 1300 may be coupled to the rear surface 1201 of the case cover 1200.

As an example, the gasket 1300 is formed to be elastically deformable to be coupled and fixed to the case cover 1200 in a forced fitting method.

The position of the gasket 1300 is not limited to what has been described above, and for example, the gasket 1300 may be provided on the frame 1130. Or, one portion of the gasket 1300 may be provided on the case cover 1200 and the other portion may be provided on the frame 1130.

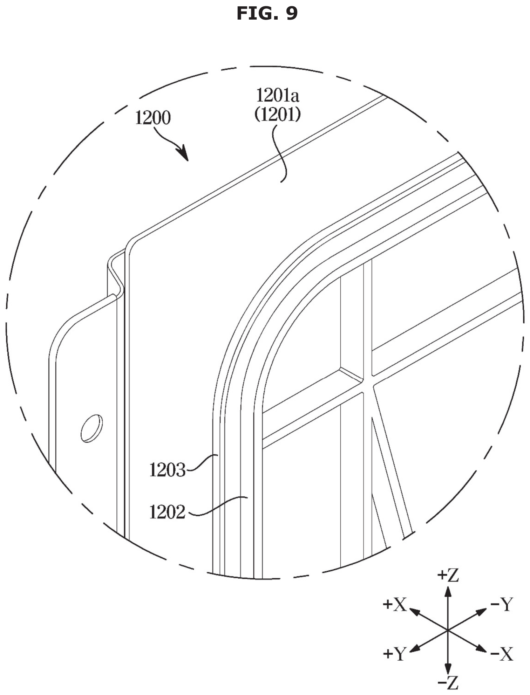

However, for convenience of explanation, the description below will be based on an embodiment in which the gasket 1300 is provided on the rear surface 1201 of the case cover 1200 with reference to FIGS. 9 to 13.

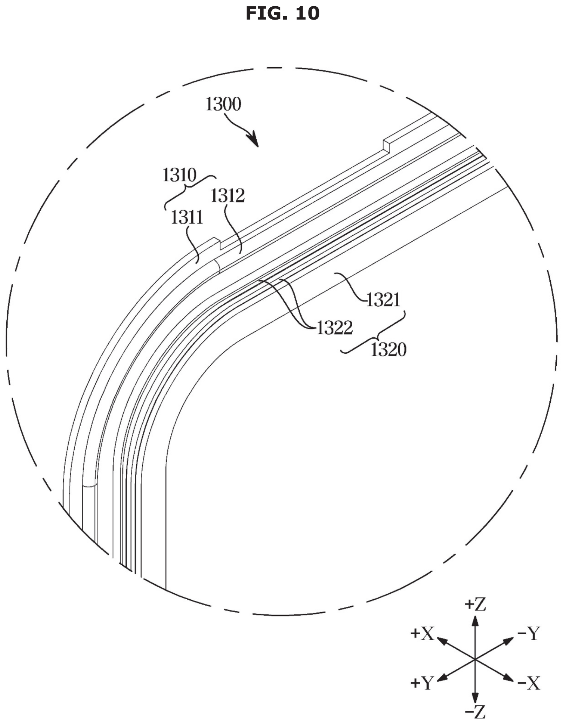

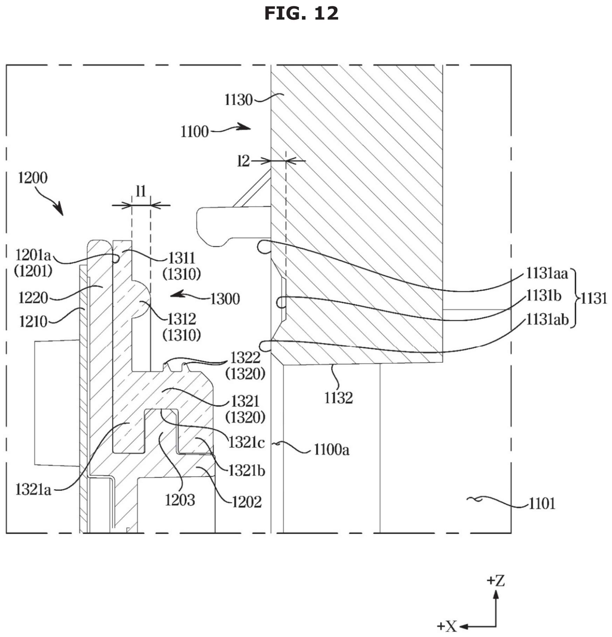

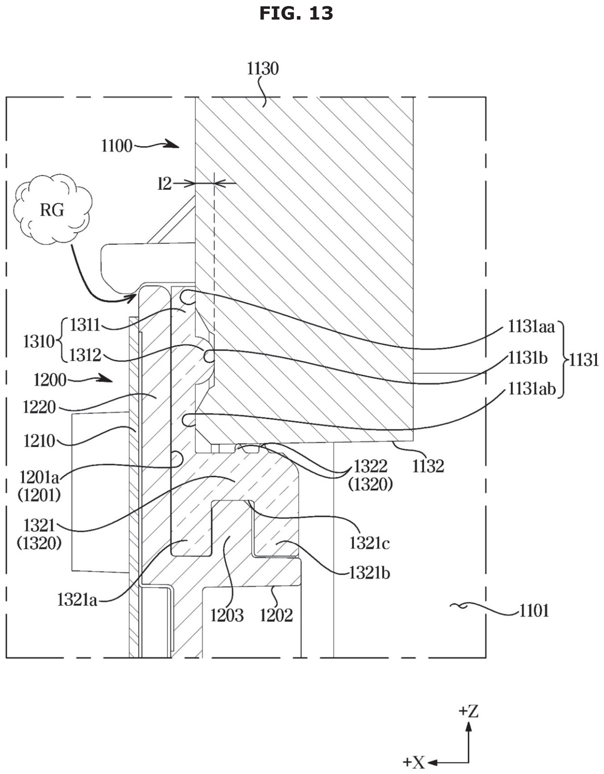

FIG. 9 is an enlarged view of a portion of a second cover included in the outdoor unit of the air conditioner according to an embodiment of the disclosure. FIG. 10 is an enlarged view of a portion of a second gasket included in the outdoor unit of the air conditioner according to an embodiment of the disclosure. FIG. 11 is an enlarged view of a portion of a second case included in the outdoor unit of the air conditioner according to an embodiment of the disclosure. FIG. 12 is a cross-sectional view illustrating that the second cover is separated from the second case in the outdoor unit of the air conditioner according to an embodiment of the disclosure. FIG. 13 is a cross-sectional view illustrating that the second cover is coupled to the second case in the outdoor unit of the air conditioner according to an embodiment of the disclosure.

Referring to FIGS. 9 to 13, the frame 1130 included in the outdoor unit 10 of the air conditioner 1 according to an embodiment of the disclosure may include the first surface 1131 and a second surface 1132.

In detail, the first surface 1131 of the frame 1130 may be arranged to face the rear surface 1201 of the case cover 1200. When the case cover 1200 is coupled to the case 1100, the rear surface 1201 of the case cover 1200 may cover at least a portion of the first surface 1131 of the frame 1130.

The first surface 1131 of the frame 1130 may be defined as one surface of the frame 1130 facing the outside of the case 1100.

In a case in which the case opening 1100a is defined as being provided in 'one direction' with respect to the accommodation space 1101 inside the case 1100, the first surface 1131 of the frame 1130 may be defined as one surface of the frame 1130 directing to 'one direction.'

As an example, the first surface 1131 of the frame 1130 may be one surface of the frame 1130 facing the front (+X direction).

The rear surface 1201 of the case cover 1200 may include a cover portion 1201a. The cover portion 1201a may be defined as a portion of the rear surface 1201 of the case cover 1200 covering the first surface 1131 of the frame 1130. Therefore, the first surface 1131 of the frame 1130 may be disposed to face the cover portion 1201a.

As an example, the cover portion 1201a may be one portion of the rear surface 1201 of the case cover 1200 located further outward in an edge direction of the case cover 1200 than the other portion on the rear surface 1201 of the case cover 1200.

The second surface 1132 of the frame 1130 may be disposed to direct to a different direction from the first surface 1131. As an example, the second surface 1132 of the frame 1130 may extend from the first surface 1131 toward the inside of the case 1100. As an example, the second surface 1132 of the frame 1130 may extend from the first surface 1131 in a direction away from the rear surface 1201 of the case cover 1200. As an example, the second surface 1132 of the frame 1130 may be disposed to direct to an inner edge direction of the case opening 1100a.

The first surface 1131 and the second surface 1132 of the frame 1130 may be connected to each other.

In the outdoor unit 10 of the air conditioner 1 according to an embodiment of the disclosure, the gasket 1300 may include a first sealing portion 1310 and a second sealing portion 1320.

The first sealing portion 1310 may be provided to be in contact with the rear surface 1201 of the case cover 1200 and the first surface 1131 of the frame 1130, respectively. The first sealing portion 1310 may be provided to seal a gap between the rear surface 1201 of the case cover 1200 and the first surface 1131 of the frame 1130. The first sealing portion 1310 may be disposed between the rear surface 1201 of the case cover 1200 and the first surface 1131 of the frame 1130. That is, the first sealing portion 1310 may be provided to be in contact with the cover portion 1201a of the case cover 1200 and the first surface 1131 of the frame 1130, respectively, so as to seal a gap between the cover portion 1201a and the first surface 1131 of the frame 1130.

In detail, the first sealing portion 1310 may only be in contact with the rear surface 1201 of the case cover 1200 when the case cover 1200 is separated from the case 1100 (see FIG. 12), and may be in contact with the case cover 1200 and the rear surface 1201, respectively, when the case cover 1200 is coupled to the case 1100 (see FIG. 13).

The second sealing portion 1320 may be provided to be in contact with the second surface 1132 of the frame 1130. As the first sealing portion 1310 and the second sealing portion 1320 are provided to be in contact with the first surface 1131 and the second surface 1132 of the frame 1130, respectively, the inside of the case 1100 may be sealed more efficiently.

In detail, as the first surface 1131 and the second surface 1132 of the frame 1130 are connected to each other, the first sealing portion 1310 and the second sealing portion 1320 may be in contact with the two surfaces of the frame 1130, respectively, in a state of being connected to each other. Accordingly, the first sealing portion 1310 and the second sealing portion 1320 may be provided to continuously block the inflow of the refrigerant through the first surface 1131 and the second surface 1132 of the frame 1130.

In a state in which the case cover 1200 is coupled to the case 1100, as illustrated in FIG. 13, refrigerant gas (RG) may be introduced into the gap between the case cover 1200 and a rear surface of the frame 1130 from an outer edge direction of the case cover 1200.

The first sealing portion 1310 may primarily prevent the inflow of the refrigerant gas (RG) by being in contact with the rear surface 1201 of the case cover 1200 and the first surface 1131 of the frame 1130, respectively, and the second sealing portion 1320 may secondarily prevent the inflow of the refrigerant gas (RG) by being in contact with the second surface 1132 of the frame 1130.

The case cover 1200 may include a cover rib 1202. The cover rib 1202 may extend from the rear surface 1201 of the case cover 1200 toward the inside of the case 1100. In other words, the cover rib 1202 may extend from the rear surface 1201 of the case cover 1200 toward the accommodation space 1101. As an example, the cover rib 1202 may extend from the rear surface 1201 of the case cover 1200 in a direction perpendicular to the rear surface 1201. As an example, the cover rib 1202 may extend from the rear surface 1201 of the case cover 1200 toward the rear (-X direction).

The cover rib 1202 may be disposed to face the second surface 1132 of the frame 1130. In this case, the cover rib 1202 may be spaced apart from the second surface 1132 of the frame 1130 by a predetermined distance, and thus a gap may be formed between the cover rib 1202 and the second surface 1132 of the frame 1130.

The second sealing portion 1320 may be provided to be in contact with the second surface 1132 of the frame 1130 and the cover rib 1202, respectively, when the case cover 1200 is coupled to the case 1100. The second sealing portion 1320 may be disposed between the cover rib 1202 and the second surface 1132 of the frame 1130. The second sealing portion 1320 may be provided to seal a gap between the second surface 1132 of the frame 1130 and the cover rib 1202.

When the case cover 1200 is coupled to the case 1100, the second sealing portion 1320 may be pressed by the cover rib 1202 and the second surface 1132 of the frame 1130. Accordingly, the second sealing portion 1320 may more efficiently block the inflow of the refrigerant.

A specific structure that the first sealing portion 1310 may have will be described below as an example.

The first sealing portion 1310 may include a first base 1311 and a first protrusion 1312.

The first base 1311 may be coupled to the rear surface 1201 of the case cover 1200. More specifically, the first base 1311 may be coupled to the cover portion 1201a.

The first protrusion 1312 may protrude from the first base 1311 toward the first surface 1131 of the frame 1130. As illustrated in FIG. 12, the first protrusion 1312 may protrude from the first base 1311 by a first length 11.

The first surface 1131 of the frame 1130 may include a base contact portion 1131a in contact with the first base 1311 when the case cover 1200 is coupled to the case 1100. As an example, the base contact portion 1131a may be provided to substantially correspond to the cover portion 1201a.

In this case, the first surface 1131 of the frame 1130 may include a recess 1131b recessed from the base contact portion 1131a in a direction away from the first base 1311. The recess 1131b may be provided at a position corresponding to the first protrusion 1312. The recess 1131b may be provided such that the first protrusion 1312 is inserted therein when the case cover 1200 is coupled to the case 1100.

The first protrusion 1312 may be provided to be inserted into the recess 1131b so as to be pressed against one surface of the recess 1131b. Herein, the one surface of the recess 1131b may refer to one surface of the recess 1131b facing the first protrusion 1312, and also may refer to one surface of the recess 1131b most depressed from the base contact portion 1131a.

The first protrusion 1312 may be provided to be elastically deformable. Accordingly, the first protrusion 1312 may be provided to be elastically deformed in a direction of being pressed when pressed by the one surface of the recess 1131b.

As an example, as illustrated in FIGS. 12 and 13, the recess 1131b may be formed to be recessed from the base contact portion 1131a by a second length l2 shorter than the first length l1. Therefore, when the case cover 1200 is coupled to the case 1100, the first protrusion 1312 may be elastically deformed and compressed, and may finally be deformed to protrude from the base 1311 by the second length 12.

As such, as the first sealing portion 1310 includes the first protrusion 1312 provided to be inserted into the recess 1131b formed on the first surface 1131 of the frame 1130 and elastically deformed, the first sealing portion 1310 may more efficiently seal the gap between the rear surface 1201 of the case cover 1200 and the first surface 1131 of the frame 1130.

As an example, the first length 11 of the first protrusion 1312 protruding from the first base 1311 may be about 1.5 mm, and the second length l2 of the recess 1131b recessed from the base contact portion 1131a may be about 1.2 mm. That is, the first protrusion 1312 may be deformed to be compressed by about 0.3 mm. However, the protrusion length and deformation length of the first protrusion 1312, and the recessed length of the recess 1131b are not limited thereto.

As an example, the first protrusion 1312 may be formed along a circumference of the case cover 1200. Correspondingly, the recess 1131b may be formed along a circumference of the case opening 1100a.

As an example, the first protrusion 1312 may be formed to protrude from a portion of the first base 1311 located between one end toward an outer side of an edge of the first base 1311 and the other end toward an inner side of the edge of the first base 1311.

As an example, the first protrusion 1312 may be formed such that a portion of a cross-section cut in a direction in which the first protrusion 1312 protrudes from the first base 1311 has a substantially semicircular shape, but the shape thereof is not limited thereto.

As an example, the first base 1311 may be formed to have a substantially flat plate shape, but the shape thereof is not limited thereto.

As an example, the base contact portion 1131a may include an outer base contact portion 1131aa and an inner base contact portion 1131ab.

The outer base contact portion 1131aa may be located on an outer side in an edge direction of the case opening 1100a with respect to the recess 1131b. The inner base contact portion 1131ab may be located on an inner side in the edge direction of the case opening 1100a with respect to the recess 1131b.

The outer base contact portion 1131aa may be provided to be in contact with the base 1311. Therefore, the base 1311 may seal a gap between the rear surface 1201 of the case cover 1200 and the outer base contact portion 1131aa on the outer side further than the first protrusion 1312 in the edge direction.

The inner base contact portion 1131ab may be provided to be in contact with the base 1311. Therefore, the base 1311 may seal a gap between the rear surface 1201 of the case cover 1200 and the inner base contact portion 1131ab on the inner side further than the first protrusion 1312 in the edge direction.

With this configuration, the first base 1311 may more efficiently seal the gap between the rear surface 1201 of the case cover 1200 and the first surface 1131 of the frame 1130.

With this configuration, the first sealing portion 1310 may more efficiently seal a gap between the case cover 1200 and the first surface 1131 of the frame 1130. However, the disclosure is not limited thereto, and the first sealing portion 1310 may have various structures.

An example of a specific structure that the second sealing portion 1320 may have will be described below.

The second sealing portion 1320 may include a second base 1321 and a second protrusion 1322.

The second base 1321 may be supported on the cover rib 1202. The second base 1321 may be supported on the cover rib 1202 to be disposed between the cover rib 1202 and the second surface 1132 of the frame 1130.

The second protrusion 1322 may protrude from the second base 1321 toward the second surface 1132 of the frame 1130.

The second protrusion 1322 may be provided to be pressed by the second surface 1132 of the frame 1130 when the case cover 1200 is coupled to the case 1100. The second protrusion 1322 may be elastically deformed and compressed while being pressed by the second surface 1132 of the frame 1130.

As an example, a plurality of the second protrusions 1322 may be provided. The plurality of second protrusions 1322 may be disposed to be spaced apart from each other.

As an example, the second base 1321 may be disposed to be spaced apart from the second surface 1132 of the frame 1130. A length of the second protrusion 1322 protruding from the second base 1321 when the case cover 1200 is separated from the case 1100 may be provided to be longer than a separation distance between the second surface 1132 of the frame 1130 and the second base 1321 when the case cover 1200 is coupled to the case 1100.

With this configuration, when the case cover 1200 is coupled to the case 1100, a resistance due to friction between the second sealing portion 1320 and the second surface 1132 of the frame 1130 may be reduced, and the gap between the cover rib 1202 and the second surface 1132 of the frame 1130 may be sealed using the second protrusion 1322.

As an example, the separation distance between the second surface 1132 of the frame 1130 and the second base 1321 when the case cover 1200 is coupled to the case 1100 may be provided to be about 0.4 mm, and a compressed length of the second protrusion 1322 may be provided to be about 0.5 mm. However, the disclosure is not limited thereto.

The second base 1321 may be coupled to the case cover 1200. As an example, the second base 1321 may be fitted into the case cover 1200.

As an example, the case cover 1200 may include a fixing rib 1203 extending from the cover rib 1202 toward the second surface 1132 of the frame 1130. The second sealing portion 1320 may include a fixing groove 1321c provided such that the fixing rib 1203 is inserted therein. As the fixing rib 1203 is inserted into the fixing groove 1321c, the second sealing portion 1320 and the case cover 1200 may be coupled.

More specifically, the second base 1321 of the second sealing portion 1320 may include a first fitting portion 1321a and a second fitting portion 1321b. The first fitting portion 1321a and the second fitting portion 1321b may each be seated on the cover rib 1202.

The fixing groove 1321c may be formed concavely between the first fitting portion 1321a and the second fitting portion 1321b. The first fitting portion 1321a and the second fitting portion 1321b may each be provided to be elastically deformable, and may be elastically biased in a direction of narrowing the fixing groove 1321c (that is, in a direction of becoming close to each other).

In this case, as the fixing rib 1203 is inserted into the fixing groove 1321c, the first fitting portion 1321a and the second fitting portion 1321b may firmly fix the fixing rib 1203.

With this configuration, the second sealing portion 1320 may more efficiently seal a gap between the case cover 1200 and the second surface 1132 of the frame 1130. However, the disclosure is not limited thereto, and the second sealing portion 1320 may have various structures.

As described with reference to FIGS. 9 to 12, the outdoor unit 10 of the air conditioner 1 according to an embodiment of the disclosure may include the gasket 1300 to efficiently seal the gap between the case cover 1200 and the frame 1130 and to seal the inside of the case 1100 more efficiently. Accordingly, foreign substances or leaked refrigerant from the outside of the case 1100 may be prevented from being introduced into the inside of the case 1100, and in particular, a fire due to the leaked refrigerant may be effectively prevented.

As an example, the gasket 1300 described above may be provided to seal a gap between the inner cover 1220 and the frame 1130, which will be described later. As an example, the rear surface 1201 of the case cover 1200 described above may refer to a rear surface of the inner cover 1220.

Therefore, structures such as the cover rib 1202 and the fixing rib 1203 described above may be provided on the inner cover 1220.

According to one embodiment, in a case in which the inner cover 1220 includes a resin material and is manufactured by the resin injection molding process, the efficiency of the manufacturing process may be further improved when the structures such as the cover rib 1202 and the fixing rib 1203 are formed on the inner cover 1220.

FIG. 14 is an exploded view of the second cover included in the outdoor unit of the air conditioner according to an embodiment of the disclosure.

Referring to FIG. 14, the outdoor unit 10 of the air conditioner 1 according to an embodiment of the disclosure may include the outer cover 1210 and the inner cover 1220. The outer cover 1210 and the inner cover 1220 may be coupled to each other to form the one case cover 1200.

The outer cover 1210 may be located in a direction toward the outside of the control box 1000. The inner cover 1220 may be located in a direction toward the inside of the case 1100. The inner cover 1220 may cover the case opening 1100a between the outer cover 1210 and the case 1100.

As an example, the outer cover 1210 may be provided at the front (+X direction) of the inner cover 1220.

The outer cover 1210 and the inner cover 1220 may include different materials.

As an example, the outer cover 1210 may include a metal material. In detail, as an example, the outer cover 1210 may be manufactured through the process of pressing a metal plate material such as a steel plate.

As an example, the inner cover 1220 may include a resin material. In detail, as an example, the inner cover 1220 may be manufactured through the resin injection molding process.

For example, when a fire occurs due to a refrigerant leaked from the inside of the outdoor unit 10, it is important to prevent the fire from spreading. In a case in which a fire occurs outside the control box 1000 and spreads to the inside of the control box 1000, the fire may become larger.

According to one embodiment, as the outer cover 1210 forming an outer surface of the control box 1000 includes a metal material, the fire may be effectively prevented from spreading to the inside of the control box 1000.

However, the outer cover 1210 formed by processing a metal material may have difficulty in providing a structure for firmly coupling the case cover 1200 to the case 1100 due to difficulties in processing. In this case, because the case cover 1200 is not fixed to the case 1100, a gap may be formed between the case cover 1200 and the case 1100, and the possibility of a refrigerant leaked through this gap to be introduced into the inside of the case 1100 may increase.

According to one embodiment, the inner cover 1220 may be manufactured through a resin injection molding process, and therefore, it may be appropriate for efficiency in the manufacturing process that a structure of being relatively complex to be processed, such as the structure for firmly coupling the case cover 1200 and the frame 1130, provided on the inner cover 1220.

In addition, because a structure formed by resin injection may have a certain elasticity, the ease of assembly between the case cover 1200 and the frame 1130 may be improved, and it may also be easier to separate the case cover 1200 from the frame 1130.

Therefore, in one embodiment of the disclosure, because the case cover 1200 includes the outer cover 1210 and the inner cover 1220, not only may the spread of a fire prevented when the fire occurs in the product, but the case cover 1200 may be firmly coupled to the case 1100.

As an example, the outer cover 1210 and the inner cover 1220 may be hook-coupled to each other. In detail, as illustrated in FIG. 14, the outer cover 1210 may include a cover hole 1211 formed to penetrate the outer cover 1210, and the inner cover 1220 may include a cover protrusion 1221 provided to penetrate the cover hole 1211 to be hook-coupled to the cover hole 1211. The cover protrusion 1221 may be formed to protrude from one surface of the inner cover 1220 facing the outer cover 1210.

As described above, because the inner cover 1220 may be manufactured through the resin injection molding process, it may be appropriate for efficiency in the manufacturing process that a structure such as the cover protrusion 1221 is provided on the inner cover 1220.

As an example, the outer cover 1210 and the inner cover 1220 may be fastened by a rivet penetrating a rivet fixing portion 1213 of the outer cover 1210 and a rivet fixing portion 1223 of the inner cover 1220, thereby being more firmly fixed to each other.

The outer cover 1210 may include a convex portion 1210a formed on one surface in contact with the inner cover 1220 to be convex toward the inner cover 1220. Correspondingly, the inner cover 1220 may include an outer cover seating surface 1220a concavely formed on one surface in contact with the outer cover 1210 in a direction away from the outer cover 1210 so that the convex portion 1210a is seated thereon.

Accordingly, the ease of assembly of the outer cover 1210 and the inner cover 1220 may be improved, and the manufacturing efficiency of the case cover 1200 may be improved.

However, the disclosure is not limited thereto, and the outer cover 1210 and the inner cover 1220 may be coupled to each other through various structures.

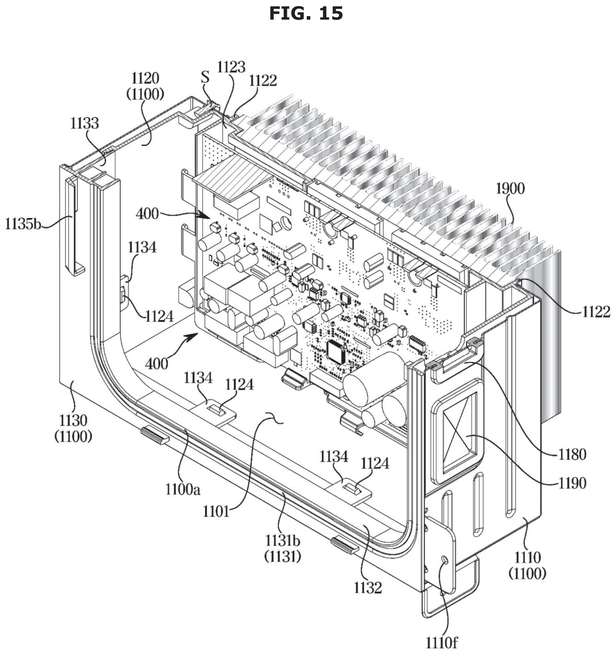

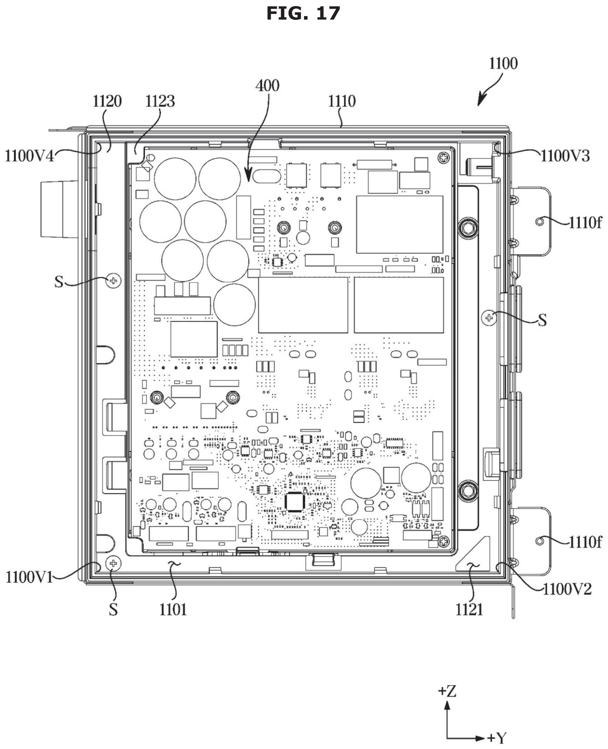

FIG. 15 is a cross-sectional perspective view of the second control box with a case cover removed in the outdoor unit of the air conditioner according to an embodiment of the disclosure. FIG. 16 is an exploded view of the second case included in the outdoor unit of the air conditioner according to an embodiment of the disclosure. FIG. 17 is a front view of a partial configuration of the second control box in the outdoor unit of the air conditioner according to an embodiment of the disclosure.

Referring to FIGS. 15 to 17, the outdoor unit 10 of the air conditioner 1 according to an embodiment of the disclosure may include the outer case 1110 and the inner case 1120. The outer case 1110 and the inner case 1120 may be coupled to each other to form the one case 1100. The inner case 1120 may be provided inside the outer case 1110. The outer case 1110 may be formed to surround the outside of the inner case 1120.

The outer case 1110 and the inner case 1120 may include different materials.

As an example, the outer case 1110 may include a metal material. In detail, as an example, the outer case 1110 may be manufactured through the process of pressing a metal plate material such as a steel plate.

As an example, the inner case 1120 may include a resin material. In detail, as an example, the inner case 1120 may be manufactured through the resin injection molding process.

According to one embodiment, as the outer case 1110 forming the outer surface of the control box 1000 includes a metal material, a fire may be effectively prevented from spreading to the inside of the control box 1000.

However, due to difficulties in processing, the outer case 1110 formed by processing a metal material may have difficulty in providing a structure for firmly coupling the case cover 1200 to the case 1100, a structure for firmly fixing the frame 1130, and a structure for stably mounting the printed circuit board 400.

According to one embodiment, the inner case 1120 may be manufactured through the resin injection molding process, and therefore, it may be appropriate for a structure of being relatively complex to be processed, such as the structure for mounting the printed circuit board 400 to the case 1100 and the structure for fixing the frame 1130, to be provided in the inner cover 1220 for efficiency in the manufacturing process.

Therefore, in one embodiment of the disclosure, as the case 1100 includes the outer case 1110 and the inner case 1120, not only may the spread of a fire be prevented when the fire occurs in the product, but the ease of assembly of the case 1100 and surrounding components thereof may be improved.

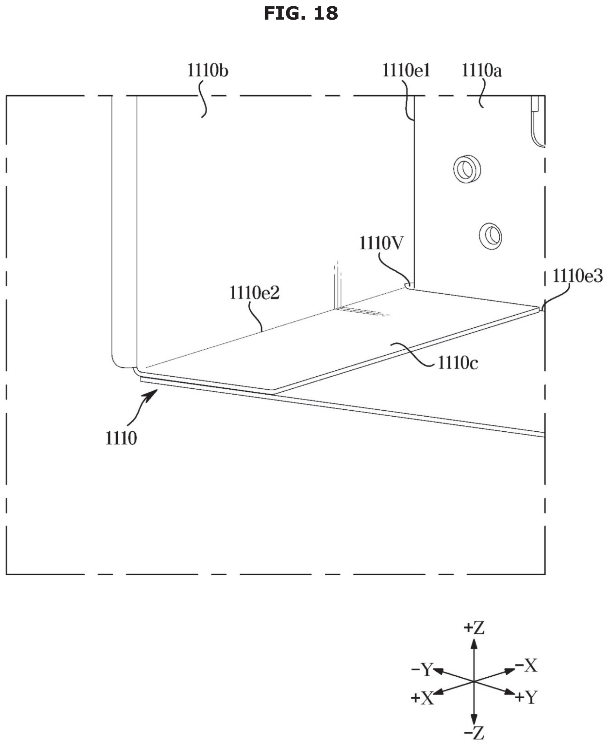

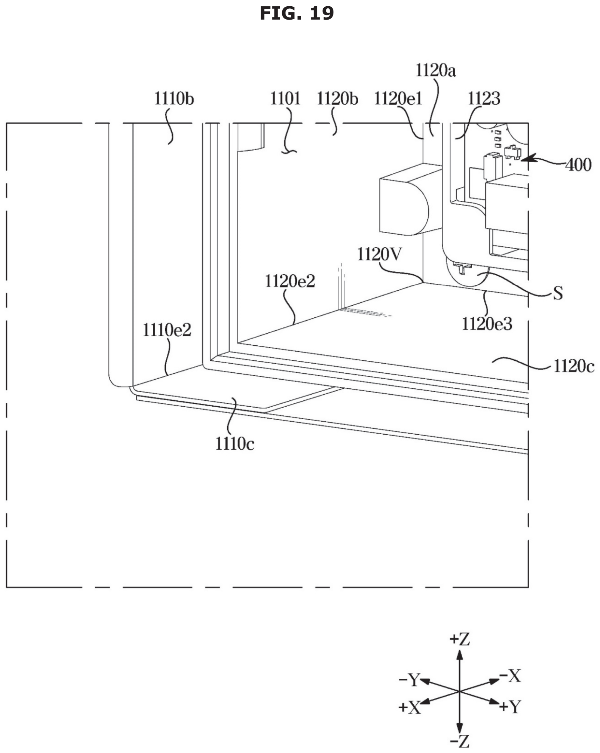

Additional effects that the inner case 1120 may provide will be described later with reference to FIGS. 18 and 19, etc.

As an example, the outer case 1110 and the inner case 1120 may be coupled to each other by being fastened by a screw S. As an example, the outer case 1110 and the inner case 1120 may be fastened by the screw S penetrating one surface of the outer case 1110 and one surface of the inner case 1120, which face the case opening 1100a, respectively.

When explained based on FIGS. 15 to 17, the outer case 1110 and the inner case 1120 may be fastened by the screw S penetrating the rear surfaces thereof.

However, the disclosure is not limited thereto, and the outer case 1110 and the inner case 1120 may be coupled through various structures.

As an example, the frame 1130 may be coupled to the inner case 1120. In detail, the frame 1130 may be provided to be hook-coupled to the inner case 1120.

As an example, the inner case 1120 may include a frame coupling part 1124 provided such that the frame 1130 is coupled thereto. Corresponding to this, the inner case 1120 may include an inner case coupling part 1134 provided to be coupled to the frame coupling part 1124. As an example, the frame coupling part 1124 may be formed to have the shape of a protrusion protruding from an inner wall of the inner case 1120, and a hole into provided to allow the frame coupling part 1124 to be inserted therein may be formed in the inner case coupling part 1134. Accordingly, the frame coupling part 1124 and the inner case coupling part 1134 may be hook-coupled to each other.

With this configuration, not only may the frame 1130 be stably fixed to the inner case 1120, but the frame 1130 and the inner case 1120 may be coupled to each other without a separate part such as a screw, thereby improving manufacturing efficiency, and the frame 1130 may be easily separated from the inner case 1120 as needed.

The frame 1130 may further include a support rib 1133 provided to be supported on the inner case 1120. The support rib 1133 may be supported on one side of the inner case 1120 in the direction of the case opening 1100a. As an example, the support rib 1133 may be formed to extend from one surface of the rear (-X direction) of the frame 1130 toward the rear (-X direction). As an example, the support rib 1133 may be provided along a circumferential direction of the frame 1130.

With this configuration, the frame 1130 may be supported more stably on the inner case 1120. When the frame 1130 is not stably fixed, a gap may be formed between the frame 1130 and the case cover 1200, and finally the refrigerant may be introduced into the case 1100 through the case opening 1100a.

However, as explained above, due to the nature of the inner case 1120 being manufactured through the resin injection process, various structures in which the frame 1130 may be fixed to the inner case 1120 may be efficiently manufactured. Therefore, the frame 1130 may be stably supported on the inner case 1120 to keep a fixed position, and finally, the refrigerant may be prevented from being introduced into the case 1100 through the case opening 1100a.

Additional structures of case 1100 in one embodiment will be described below.

As an example, the case 1100 may include a board mounting portion 1123 provided such that the printed circuit board 400 is mounted thereon. The board mounting portion 1123 may be formed to protrude from an inner surface of the case 1100, for example, one surface on the rear (-X direction) side opposite the case opening 1100a to support the board mounting portion 1123.

As an example, the heat sink 1900 may penetrate one side of the case 1100 and be connected to the printed circuit board 400. As an example, a heat sink mounting hole 1112 provided to allow the heat sink 1900 to penetrate through may be formed on one surface of the outer case 1110. On one surface of the inner case 1120 corresponding to the one surface of the outer case 1110 on which the heat sink mounting hole 1112 is formed, a heat sink connection hole 1122h may be formed to allow the heat sink 1900 to be connected to the printed circuit board 400. The heat sink 1900 may be connected to the printed circuit board 400 by sequentially passing through the heat sink mounting hole 1112 and the heat sink connection hole 1122h.

In this case, as an example, a heat sink support portion 1122 supporting the heat sink 1900 may be provided on the one surface of the inner case 1120 through which the heat sink 1900 penetrates. The heat sink support portion 1122 may extend to penetrate the heat sink mounting hole 1112 of the outer case 1110. The heat sink support portion 1122 may be provided along an edge of the heat sink mounting hole 1112 to firmly support the heat sink 1900. In detail, the heat sink support portion 1122 may be formed continuously along the edge of the heat sink mounting hole 1112 to support the heat sink 1900 more firmly.

It may be more efficient for the various structures provided on the inner case 1120 described above to be manufactured to be provided on the inner case 1120 due to differences in manufacturing processes between the outer case 1110 and the inner case 1120.

FIG. 18 illustrates a second outer case included in the outdoor unit of the air conditioner according to an embodiment of the disclosure.

Referring to FIG. 18, the outer case 1110 included in the outdoor unit 10 of the air conditioner 1 according to an embodiment of the disclosure may include a first outer case surface 1110a facing the case opening 1110a, a second outer case surface 1110b disposed between the first outer case surface 1110a and the case opening 1110a, and a third outer case surface 1110c orthogonal to and in contact with the second outer case surface 1110b and disposed between the first outer case surface 1110a and the case opening 1100a.

In this case, one vertex 1110V formed between the first outer case surface 1110a, the second outer case surface 1110b, and the third outer case surface 1110c among vertices of the outer case 1110 may be defined.

In other words, when a first outer case edge 1110e1 where the first outer case surface 1110a and the second outer case surface 1110b meet, a second outer case edge 1110e2 where the second outer case surface 1110b and the third outer case surface 1110c meet, and a third outer case edge 1110e3 where the third outer case surface 1110c and the first outer case surface 1110a meet are defined, the one vertex 1110V provided adjacent to a point where extension lines of the first outer case edge 1110e1, the second outer case edge 1110e2, and the third outer case edge 1110e3 intersect may be defined.

In this case, at the vertex 1110V of the outer case 1110, as illustrated in FIG. 18, a gap may be formed to connect the inside and outside of the outer case 1110. In other words, at the vertex 1110V of outer case 1110, a hole may be formed to communicate the inside and outside of the outer case 1110.

This structure may be especially effective when the outer case 1110 is manufactured by processing a metal material for purposes such as preventing the spread of fire, as described above. In a case in which the outer case 1110 is manufactured in a box shape by bending a flat metal plate material, due to the nature of the manufacturing process, manufacturing such that a gap is not formed at the vertex 1110V may be very difficult due to the nature of the manufacturing process.

Because the outer case 1110 is disposed in the machine room R2, the vertex 1110V of the outer case 1110 may be exposed to the machine room R2. That is, the gap formed at the vertex 1110V of the outer case 1110 may connect the machine room R2 and the inside of the outer case 1110.

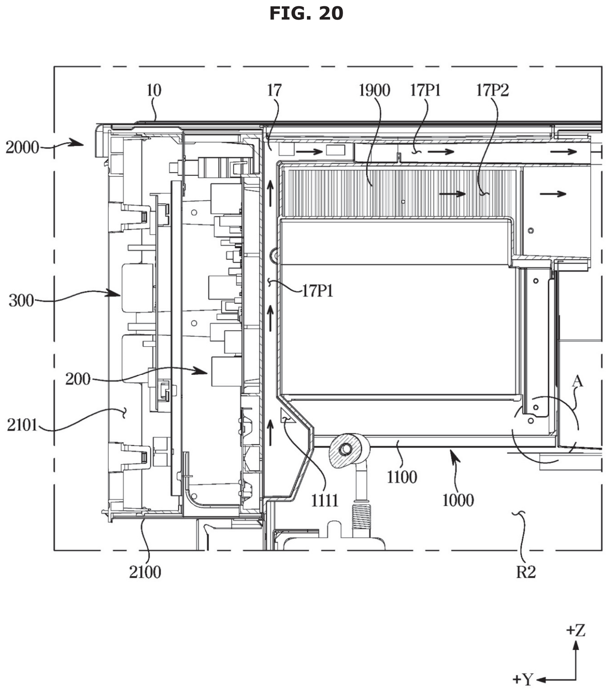

When explained using the vertex 1110V of the outer case 1110 located in area A shown in FIG. 20 as an example, in a case in which a flammable refrigerant leaks from any of the components of outdoor unit 10 disposed in the machine room R2, as illustrated in FIGS. 18 and 20, the refrigerant may be easily introduced into the outer case 1110 through the gap formed at the vertex 1110V of the outer case 1110 facing the machine room R2.

As such, when the refrigerant introduced into the outer case 1110 is directly introduced into the inner case 1120, as previously explained, there is a possibility that a fire may occur due to the refrigerant being exposed to the electronic components or circuits.

FIG. 19 illustrates the inside of the second case included in the outdoor unit of the air conditioner according to an embodiment of the disclosure.

Referring to FIG. 19, the inner case 1120 included in the outdoor unit 10 of the air conditioner 1 according to an embodiment of the disclosure may include a first inner case surface 1120a facing the case opening 1110a, a second inner case surface 1120b disposed between the first inner case surface 1120a and the case opening 1110a, and a third inner case surface 1120c orthogonal to and in contact with the second inner case surface 1120b and disposed between the first inner case surface 1120a and the case opening 1100a.

In this case, the first inner case surface 1120a may correspond to the first outer case surface 1110a, the second inner case surface 1120b may correspond to the second outer case surface 1110b, and the third inner case surface 1120c may correspond to the third outer case surface 1110c.

Herein, the meaning of 'the outer case surface and the inner case surface correspond to each other' means that the corresponding outer case surface and inner case surface are parallel to each other and are provided on the same side of the case.

In this case, one vertex 1120V formed between the first inner case surface 1120a, the second inner case surface 1120b, and the third inner case surface 1120c among vertices of the inner case 1120 may be defined.

In other words, when a first inner case edge 1120e1 where the first inner case surface 1120a and the second inner case surface 1120b meet, a second inner case edge 1120e2 where the second inner case surface 1120b and the third inner case surface 1120c meet, and a third inner case edge 1120e3 where the third inner case surface 1120c and the first inner case surface 1120a meet are defined, the one vertex 1120V provided adjacent to a point where extension lines of the first inner case edge 1120e1, the second inner case edge 1120e2, and the third inner case edge 1120e3 intersect may be defined.

In this case, at the vertex 1120V of the inner case 1120, as illustrated in FIG. 19, the block portion 1120V may be formed to block the inside and outside of the inner case 1120. That is, the vertex 1120V where the first inner case surface 1120a, the second inner case surface 1120b, and the third inner case surface 1120c meet each other may be completely blocked.

As an example, as described above, the inner case 1120 may include a resin material. In detail, the inner case 1120 may be formed through the resin injection molding process, so that it may be relatively easy to manufacture the inner case 1120 such that the block portion 1120V is formed at a vertex as described above.

The block portion 1120V of the inner case 1120 as described above may be provided to block the gap formed at the vertex 1110V of the outer case 1110 and the accommodation space 1101 formed inside the inner case 1120.

With this configuration, the inside of the inner case 1120 is separated from the outer case 1110, so that the inside of the inner case 1120 may be sealed more efficiently. Accordingly, even when the refrigerant leaked from the machine room R2 is introduced into the outer case 1110, the refrigerant may be prevented from being introduced into the inner case 1120, and furthermore, the occurrence of fire caused by the leaked refrigerant may be effectively prevented.

The first inner case surface 1120a of the inner case 1120 may be coupled to be in contact with the first outer case surface 1110a of the outer case 1110. As an example, the first inner case surface 1120a and the first outer case surface 1110a may be in contact with each other by being fastened to each other by the screw S. When explained based on the drawing, the outer case 1110 and the inner case 1120 may be fastened by the screw S penetrating the rear surfaces thereof, and the rear surfaces may be in contact with each other.

As described above, according to one example, the outer case 1110 and the inner case 1120 may each be formed such that the rear surfaces thereof are penetrated by the heat sink 1900. Therefore, the rear surface of the outer case 1110 and the rear surface of the inner case 1120 are configured to be in contact with each other, so that the refrigerant, which is introduced into the outer case 1110 through the gap formed at the vertex 1110V of the outer case 1110, may be prevented from being introduced into the inner case 1120 through a gap formed on the rear surface of the inner case 1120 (that is, a gap formed in a portion penetrated by the heat sink 1900).

However, the disclosure is not limited thereto, and the outer case 1110 and the inner case 1120 may be provided such that various surfaces thereof are in contact with each other.

The structures of the vertex 1110V of the outer case 1110 and the vertex 1120V of the inner case 1120 as described above may be applied to vertices 1100V1, 1100V2, 1100V3, and 1100V4 formed at rear (-X direction) portions of the case 1100 illustrated in FIG. 17.

FIG. 20 is a view illustrating that the outdoor unit of the air conditioner is cut away and viewed from the rear according to an embodiment of the disclosure.

Referring to FIG. 20, the outdoor unit 10 of the air conditioner 1 according to an embodiment of the disclosure may include the duct 17 connected to the inside of the control box 1000. The duct 17 may communicate the control box 1000 and the heat exchange room R1.

As illustrated in FIG. 20, the duct 17 may include a first duct flow path 17P1 and a second duct flow path 17P2.

For example, the duct 17 may be provided to dissipate heat inside the control box 1000 through the first duct flow path 17P1 and the second duct flow path 17P2.

The outer case 1110 may include a first duct connection hole 1111 connected to the duct 17. The inner case 1120 may include a second duct connection hole 1121 (see FIG. 17) formed at a position corresponding to the first duct connection hole 1111.

In this case, an internal space of the inner case 1120 may be connected to the first duct flow path 17P1 of the duct 17 through the first duct connection hole 1111 and the second duct connection hole 1121.

In addition, the duct 17 may be coupled to one side (e.g., the rear (-X direction)) of the heat sink 1900, and the heat sink 1900 may be connected to the second duct flow path 17P2.

In this configuration, when the outdoor fan 13 in the heat exchange room R1 is driven, an air flow may be formed from the first duct flow path 17P1 and the second duct flow path 17P2 toward the heat exchange room R1 due to a pressure difference generated by the outdoor fan 13.

By this principle, heat inside the case 1100 may be dissipated to the outside.

On the other hand, despite the structure of the control box 1000 according to an embodiment of the disclosure described with reference to FIGS. 7 to 19, the refrigerant leaked from the machine room R2 may be introduced into the case 1100 for various reasons.

Even in this case, the inside of the case 1100 may be connected to the duct 17, and the refrigerant introduced into the case 1100 when the outdoor fan 13 is driven may pass through the heat exchange room R1 and the discharge hole 111 through the duct 17 (through the first duct flow path 17P1, based on FIG. 20) and then be discharged to the outside of the outdoor unit 10.

With this configuration, despite the refrigerant leaked, the risk of fire occurring due to parts within the control box 1000 being exposed to the refrigerant may be prevented.

Although not described above, the duct 17 may also be connected to the second control box 2000, and the same functions as those described above may also be provided for the second control box 2000.

In addition, the structures of the control boxes 1000 and 2000 described above may be applied to control boxes provided in various types of devices in addition to the outdoor unit 10 of the air conditioner 1 according to an embodiment of the disclosure.

An outdoor unit of the air conditioner according to an embodiment of the disclosure may include a case 1100 configured to accommodate the printed circuit board 400 therein and including a case opening 1100a formed on one side of the case and a frame 1130 provided along an edge of the case opening, a case cover 1200 configured to cover at least a portion of the frame and the case opening and having a rear surface 1201 facing the inside of the case, and a gasket 1300 configured to seal a gap between the case cover and the frame. The frame 1130 may include a first surface 1131 disposed to face the rear surface of the case cover, and a second surface 1132 extending from the first surface toward the inside of the case. The gasket 1300 may include a first sealing portion 1310 configured to be in contact with the rear surface of the case cover and the first surface of the frame, and a second sealing portion 1320 configured to be in contact with the second surface of the frame.

The first sealing portion 1310 may include a base 1311 coupled to the rear surface of the case cover, and a protrusion 1312 protruding from the base toward the first surface of the frame. The first surface 1131 of the frame may include a base contact portion 1131a in contact with the base, and a recess 1131b configured to be recessed from the base contact portion in a direction away from the base to allow the protrusion to be inserted therein.

The protrusion 1312 may be configured to be pressed against one surface of the recess by being inserted into the recess and elastically deformed in a direction of being pressed by the one surface of the recess.

The base contact portion 1131a may include an outer base contact portion 1131aa located on an outer side in an edge direction of the case opening with respect to the recess, and an inner base contact portion 1131ab located on an inner side in the edge direction of the case opening with respect to the recess. The outer base contact portion and the inner base contact portion may each be configured to be in contact with the base.

The protrusion 1312 may be formed along a circumference of the case cover 1200. The recess 1131b may be formed along a circumference of the case opening 1100a.

The case cover 1200 may include a cover rib 1202 extending from the rear surface of the case cover toward the inside of the case and disposed to face the second surface of the frame. The second sealing portion 1320 may be disposed between the cover rib and the second surface of the frame.

The second sealing portion 1320 may include a base 1321 supported on the cover rib and disposed to be spaced apart from the second surface of the frame, and a protrusion 1322 protruding from the base toward the second surface of the frame. The protrusion 1322 may be configured to be pressed against the second surface 1132 of the frame.

The protrusion 1322 may include a plurality of ribs. The plurality of ribs may be configured to elastically deform towards the base 1321 when pressed against the second surface 1132 of the frame.

The plurality of ribs may be disposed apart from each other by a predetermined distance.

The case cover 1200 may further include a fixing rib 1203 extending from the cover rib toward the second surface of the frame. The second sealing portion 1320 may further include a fixing groove 1321c into which the fixing rib is inserted so that the second sealing portion and the case cover are coupled.

The outdoor unit of the air conditioner may further include a machine room R2 in which a compressor is disposed. The case may further include the outer case 1110 disposed in the machine room, and the inner case 1120 provided inside the outer case to form an accommodation space in which the printed circuit board is accommodated.

The outer case 1110 may include a first outer case surface 1110a facing the case opening, a second outer case surface 1110b disposed between the first outer case surface and the case opening, and a third outer case surface 1110c orthogonal to and in contact with the second outer case surface and disposed between the first outer case surface and the case opening. A gap connecting the machine room and the inside of the outer case may be formed at a vertex 1110V of the outer case formed between the first outer case surface, the second outer case surface, and the third outer case surface. The inner case 1120 may include a first inner case surface 1120a corresponding to the first outer case surface, a second inner case surface 1120b corresponding to the second outer case surface, and a third inner case surface 1120c corresponding to the third outer case surface. A block portion 1120V may be provided at a vertex of the inner case formed between the first inner case surface, the second inner case surface, and the third inner case surface. The block portion 1120V may be configured to block the gap formed at the vertex 1110V of the outer case and the accommodation space 1101.

The first inner case surface 1120a may be coupled to be in contact with the first outer case surface 1110a.

The outer case 1110 may include a metal material. The inner case 1120 may include a resin material.

The frame 1130 may be hook-coupled to the inner case 1120.

The case cover 1200 may include an outer cover 1210 including a metal material, and an inner cover 1220 coupled to the outer cover to cover the case opening between the outer cover and the case and including a resin material.

The gasket 1300 may be coupled to a rear surface of the inner cover to seal a gap between the inner cover and the frame.

An outdoor unit of the air conditioner according to an embodiment of the disclosure may include a case 1100 configured to accommodate a printed circuit board therein and including a case opening 1100a formed on one side of the case and a frame 1130 provided along an edge of the case opening, a case cover 1200 configured to be able to be coupled to the case to cover at least a portion of the frame and the case opening when coupled to the case, and a gasket 1300 configured on a rear surface 1201 of the case cover to seal the gap between the case cover and the frame when the case cover is coupled to the case. The gasket may include a first sealing portion 1310 configured to be in contact with a first surface 1131 of the frame facing the rear surface of the case cover when the case cover is coupled to the case, and a second sealing portion 1320 configured to be in contact with a second surface 1132 of the frame extending from the first surface toward the inside of the case when the case cover is coupled to the case.

The first sealing portion 1310 may include a base 1311 and a protrusion 1312 protruding from the base by a first length when the case cover is separated from the case. The first surface 1131 of the frame may include a base contact portion 1131a configured to be in contact with the base when the case cover is coupled to the case, and a recess 1131b formed to be recessed from the base contact portion by a second length shorter than the first length. The protrusion may be configured to be inserted into the recess when the case cover is coupled to the case.

The case cover 1200 may include a cover rib 1202 extending from the rear surface of the case cover in a direction orthogonal to the rear surface of the case cover. The cover rib may be configured to face the second surface of the frame when the case cover is coupled to the case. The second sealing portion 1320 may be configured to seal a gap between the cover rib and the second surface of the frame when the case cover is coupled to the case.

The second sealing portion 1320 may include a base 1321 supported on the cover rib and disposed to be spaced apart from the second surface of the frame, and a protrusion 1322 protruding from the base toward the second surface of the frame. The protrusion may be configured to be pressed against the second surface of the frame.

An outdoor unit of the air conditioner according to an embodiment of the disclosure may include a printed circuit board, a case 1100 forming an accommodation space 1101 in which the printed circuit board is accommodated and including a case opening 1100a formed on one side of the accommodation space, and the frame 1130 provided along the circumference of the case opening, the case cover 1200 covering at least a portion of the frame and the case opening, and the gasket 1300 disposed between the case cover and the frame. The case cover 1200 may include the rear surface 1201 facing the accommodation space and the cover rib 1202 protruding from the rear surface toward the accommodation space. The frame 1130 may include the first surface 1131 facing the rear surface of the case cover, and the second surface 1132 connected to the first surface and facing the cover rib. The gasket may include the first sealing portion 1310 configured to seal the gap between the first surface and the rear surface of the case cover, and the second sealing portion 1320 configured to seal the gap between the second surface and the cover rib.

According to the disclosure, an outdoor unit of an air conditioner includes a gasket configured to seal a gap between a case cover of a control box and a case, thereby preventing foreign substances from being introduced into the control box.

According to the disclosure, the outdoor unit of the air conditioner includes a gasket configured to seal the gap between the case cover of the control box and the case, thereby preventing a refrigerant from being introduced into the control box.

According to the disclosure, the outdoor unit of the air conditioner includes a gasket configured to seal the gap between the case cover of the control box and the case, thereby preventing a fire from occurring due to flammable substances coming into contact with electronic components or electric wires inside the control box.

According to the disclosure, the outdoor unit of the air conditioner includes an outer case and an inner case made of different materials, thereby preventing the spread of a fire caused by flammable substances inside the outdoor unit.

According to the disclosure, the outdoor unit of the air conditioner includes an outer cover and an inner cover made of different materials, thereby preventing the spread of a fire caused by flammable substances inside the outdoor unit.

Effects obtainable from the disclosure are not limited to the effects mentioned above, and other effects not mentioned will be clearly understood by those skilled in the art from the description below.

While the disclosure has been shown and described with reference to various embodiments thereof, it will be understood by those skilled in the art that various changes in form and details may be made therein without departing from the spirit and scope of the disclosure as defined by the appended claims and their equivalents.

## Claims

1. An outdoor unit of an air conditioner comprising:
a case configured to accommodate a printed circuit board therein and comprising a case opening formed on one side of the case and a frame provided along an edge of the case opening;
a case cover configured to cover at least a portion of the frame and the case opening and having a rear surface facing inside of the case; and
a gasket configured to seal a gap between the case cover and the frame,
wherein the frame comprises:
a first surface disposed to face the rear surface of the case cover, and
a second surface extending from the first surface toward the inside of the case, and
wherein the gasket comprises:
a first sealing portion configured to be in contact with the rear surface of the case cover and the first surface of the frame, and
a second sealing portion configured to be in contact with the second surface of the frame.

2. The outdoor unit according to claim 1,
wherein the first sealing portion comprises:
a base coupled to the rear surface of the case cover, and
a protrusion protruding from the base toward the first surface of the frame, and
wherein the first surface of the frame comprises:
a base contact portion in contact with the base, and
a recess configured to be recessed from the base contact portion in a direction away from the base to allow the protrusion to be inserted therein.

3. The outdoor unit according to claim 2, wherein the protrusion is configured to be pressed against one surface of the recess by being inserted into the recess and elastically deformed in a direction of being pressed by the one surface of the recess.

4. The outdoor unit according to claim 2,
wherein the base contact portion comprises:
an outer base contact portion located on an outer side in an edge direction of the case opening with respect to the recess, and
an inner base contact portion located on an inner side in the edge direction of the case opening with respect to the recess, and
wherein the outer base contact portion and the inner base contact portion each are configured to be in contact with the base.

5. The outdoor unit according to claim 2,
wherein the protrusion is formed along a circumference of the case cover, and
wherein the recess is formed along a circumference of the case opening.

6. The outdoor unit according to claim 1,
wherein the case cover comprises a cover rib extending from the rear surface of the case cover toward the inside of the case and disposed to face the second surface of the frame, and
wherein the second sealing portion is disposed between the cover rib and the second surface of the frame.

7. The outdoor unit according to claim 6,
wherein the second sealing portion comprises:
a base supported on the cover rib and disposed to be spaced apart from the second surface of the frame, and
a protrusion protruding from the base toward the second surface of the frame, and wherein the protrusion is configured to be pressed against the second surface of the frame.

8. The outdoor unit according to claim 7,
wherein the protrusion comprises a plurality of ribs, and
wherein the plurality of ribs are configured to elastically deform towards the base when pressed against the second surface of the frame.

9. The outdoor unit according to claim 8, wherein the plurality of ribs are disposed apart from each other by a predetermined distance.

10. The outdoor unit according to claim 6,
wherein the case cover further comprises a fixing rib extending from the cover rib toward the second surface of the frame, and
wherein the second sealing portion further comprises a fixing groove into which the fixing rib is inserted so that the second sealing portion and the case cover are coupled.

11. The outdoor unit according to claim 1, further comprising:
a machine room in which a compressor is disposed,
wherein the case further comprises:
an outer case disposed in the machine room, and
an inner case provided inside the outer case to form an accommodation space in which the printed circuit board is accommodated.

12. The outdoor unit according to claim 11,
wherein the outer case comprises:
a first outer case surface facing the case opening,
a second outer case surface disposed between the first outer case surface and the case opening,
a third outer case surface orthogonal to and in contact with the second outer case surface and disposed between the first outer case surface and the case opening, and
a gap connecting the machine room and the inside of the outer case is formed at a vertex of the outer case formed between the first outer case surface, the second outer case surface, and the third outer case surface,
wherein the inner case comprises:
a first inner case surface corresponding to the first outer case surface,
a second inner case surface corresponding to the second outer case surface, and
a third inner case surface corresponding to the third outer case surface,
wherein a block portion is provided at a vertex of the inner case formed between the first inner case surface, the second inner case surface, and the third inner case surface, and
wherein the block portion is configured to block the gap formed at the vertex of the outer case and the accommodation space.

13. The outdoor unit according to claim 12, wherein the first inner case surface is coupled to be in contact with the first outer case surface.

14. The outdoor unit according to claim 11, wherein the outer case comprises a metal material, and the inner case comprises a resin material.

15. The outdoor unit according to claim 11, wherein the frame is hook-coupled to the inner case.
